# EUROPEAN PATENT APPLICATION

(11) **EP 4 582 816 A1**
(43) Date of publication of application: **09.07.2025**
(21) Application number: 23871499.2
(22) Date of filing: 09.08.2023
(51) Int. Cl.: G01R 1/22, G01R 15/20

(54) **CLAMP SENSOR AND MEASURING DEVICE**

(30) Priority: 29.09.2022 JP 2022155686; 16.06.2023 JP 2023098906
(71) Applicant: Hioki E.E. Corporation, Ueda-shi, Nagano 386-1192 (JP)
(72) Inventor: WATANABE Hideo, Ueda-shi Nagano 386-1192 (JP); YAMAGISHI Kimihiko, Ueda-shi Nagano 386-1192 (JP)
(74) Representative: Novagraaf International SA
(86) International application number: PCT/JP2023/029021
(87) International publication number: WO 2024/070257

(57) **Abstract**

The object of the present invention is to cause both core members to adopt a state of being coupled together with a sufficient magnetic coupling force, while achieving a reduction in size. This clamp sensor includes a first core member 21 constituting a part, in a circumferential direction, of a magnetic core 20 that is arranged annularly, and a second core member 22 constituting another part thereof. The clamp sensor is configured such that: first protruding portions that protrude along the circumferential direction are provided at tip ends P21a and P21b in the circumferential direction of the member 21, and second protruding portions that protrude along the circumferential direction are provided at tip ends P22a and P22b in the circumferential direction of the member 22; and in a closed state, the first protruding portions on the tip end P21a side and the second protruding portions on the tip end P22a side overlap in an insertion direction, and the first protruding portions on the tip end P21b side and the second protruding portions on the tip end P22b side overlap in the insertion direction.

## Description

### TECHNICAL FIELD

The present invention relates to: a clamp sensor including a magnetic core provided with two core members and arranged annularly in a closed state; and a measuring device configured to include such a clamp sensor.

### BACKGROUND ART

As this type of clamp sensor, the applicant discloses, in the Patent Document described below, a clamp sensor including a body portion in which a first core unit is arranged at a clamp portion provided on one end side of a body case, and a slide portion in which a second core unit is arranged on one end side (a tip end portion) of a slide case slidably arranged along the longitudinal direction of the body portion.

In this clamp sensor, a slide knob of the slide case protrudes from a long hole-shaped window portion formed in the body case, and the slide case can be slid to an open position or to a closed position with respect to the body case, by moving the slide knob along the longitudinal direction of the body portion. In this case, the first core unit includes a first sensor portion including a U-shaped first core forming a part of a magnetic circuit, and a shield body arranged so as to surround the first core. In addition, the second core unit includes a second sensor unit including a rectangular parallelepiped second core forming another part of the magnetic circuit, and a shield body arranged so as to surround the second core.

In addition, in this clamp sensor, end surfaces of both leg portions of the first core are formed in a planar shape so that side surfaces of the second core can be brought into surface contact with the end surfaces. Further, in this clamp sensor, a configuration is adopted in which, when the slide case is slid to the closed position, the second core unit arranged in the slide case is urged toward the first core unit arranged in the body case.

When a detection amount of, for example, a current flowing through a detection target (for example, an electric wire) is detected by the clamp sensor, the detection target such as the electric wire or the like is inserted into the clamp portion (slit) of the body portion in a state in which the slide case is slid to the open position. Subsequently, the slide case is slid to the closed position to clamp the detection target. At this time, the second core unit is urged toward the first core unit, and thus the side surfaces of the second core come into surface contact with the end surfaces of both the leg portions of the first core and come into close contact therewith. In this way, an annular closed magnetic circuit is formed around the detection target by the first core and the second core, and a magnetic field generated by the current flowing through the detection target can be detected.

### CITATION LIST

### PATENT LITERATURE

Patent Document 1: JP 2016-045187 A (pages 8 to 20, FIGS. 1 to 37)

### SUMMARY OF INVENTION

### TECHNICAL PROBLEM

However, the clamp sensor disclosed by the applicant has the following issues to be solved. Specifically, in the clamp sensor disclosed by the applicant, a configuration is adopted in which the second core unit is urged toward the first core unit when the slide case is slid to the closed position, and thus the side surfaces of the second core come into close surface contact with the end surfaces of both the leg portions of the first core, and the annular closed magnetic circuit is formed around the detection target by the first core and the second core.

In this case, the clamp sensor disclosed by the applicant adopts a slide structure. In this way, since a space required for bringing the clamp sensor into an open state is made narrower than that of a clamp sensor having a structure in which the clamp sensor is opened and closed by rotating a clamp arm about a rotation axis, it is possible to easily clamp the detection target in a narrow space. However, in order to reliably and more easily clamp the detection target in the narrow space, it is necessary to further reduce the size of the clamp sensor. Therefore, in this type of clamp sensor, it is necessary to reduce the cross-sectional area (cross-sectional area in a direction intersecting the annular closed magnetic circuit) of the magnetic core for forming the annular closed magnetic circuit around the detection target. As a result, it tends to be difficult to couple the first core and the second core (a pair of core members) constituting the magnetic core with a sufficient magnetic coupling force. Therefore, it is preferable to improve this point.

In addition, in the clamp sensor, when an unintended external force is applied to the body case or the slide case in a state in which the detection target is clamped, a small distortion may occur in both the cases. In such a case, the first core and the second core accommodated in the case may become inclined, and it may be difficult to maintain a state in which the first core and the second core are in surface contact with each other. In addition, when the clamp sensor disclosed by the applicant is used to detect the detection amount, small foreign matter may be caught between the end surfaces of both the leg portions of the first core and the side surface of the second core. In such a case, a small gap corresponding to the size of the foreign matter is generated between the first core and the second core.

As described above, in the clamp sensor disclosed by the applicant, when the case accommodating the two cores is distorted, or when foreign matter is caught between the end surfaces of the two cores, the contact area between the first core and the second core may be reduced or a small gap may be unexpectedly formed in the annular closed magnetic circuit for detecting the detection amount. As a result, there is a risk that the magnetic coupling force between the first core and the second core may be reduced. In addition, the size of the gap generated in the closed magnetic circuit may change depending on the degree of distortion generated in the case and the size of the foreign matter interposed between the end surfaces. Therefore, it is preferable to improve this point.

The present invention has been made in view of such issues to be solved, and a main object thereof is to provide a clamp sensor capable of achieving a state in which both core members are coupled to each other with a sufficient magnetic coupling force while realizing a reduction in size, and a measuring device including such a clamp sensor. Another object is to provide a clamp sensor capable of clamping a detection target conductor without causing an unexpected gap in a closed magnetic circuit formed around the detection target conductor, and a measuring device including such a clamp sensor.

### SOLUTION TO PROBLEM

A clamp sensor according to the present invention includes a first core member constituting a part, in a circumferential direction, of a magnetic core arranged annularly in a closed state, and a second core member formed separately from the first core member, the second core member constituting another part, in the circumferential direction, of the magnetic core. The clamp sensor includes a first case accommodating the first core member, and a second case configured to be slidable relative to the first case and accommodating the second core member. When the magnetic core is transitioned to the closed state and arranged annularly, and the magnetic core is viewed along an insertion direction of a detection target conductor with respect to the magnetic core, the second case is configured to be slidable relative to the first case along a virtual straight line intersecting an inner circumferential side edge portion of the magnetic core at either of both of end portions, in the circumferential direction, of the first core member. A first protruding portion protruding in the circumferential direction is provided at at least one end portion, of both the end portions in the circumferential direction of the first core member, and a second protruding portion protruding in the circumferential direction is provided at at least one end portion, of both of end portions in the circumferential direction of the second core member. In the state in which the magnetic core is transitioned to the closed state and arranged annularly, the first protruding portion and the second protruding portion are configured to overlap each other in the insertion direction.

Further, a measuring device according to the present invention includes the clamp sensor described above, and a measuring unit. The measuring unit is configured to measure a measurement amount defined in advance based on a detection amount, by the clamp sensor, of the detection target conductor inserted in the insertion direction with respect to the magnetic core.

Therefore, compared to a clamp sensor having a structure in which both end portions in the circumferential direction of a first core member and both end portions in the circumferential direction of a second core member are each formed in a planar shape orthogonal to the circumferential direction, and an end surface of the first core member and an end surface of the second core member make surface contact in the closed state, the clamp sensor and the measuring device according to the present invention can increase, when viewed along the insertion direction in the closed state, the contact area between the first core member and the second core member in the closed state by causing mutual contact between portions (a side surface of the first protruding portion and a side surface of the second protruding portion) in which the first protruding portion provided at the at least one end portion of both end portions in the circumferential direction of the first core member overlaps the second protruding portion provided at the at least one end portion of both end portions in the circumferential direction of the second core member. In this way, even when the size of the magnetic core is reduced, the first core member and the second core can be coupled together with a sufficient magnetic coupling force in the closed state. As a result, the clamp sensor can be further reduced in size and the detection target conductor can be reliably and easily clamped even in a narrow place. The sensitivity of the clamp sensor can thus be further improved.

In addition, in the clamp sensor according to the present invention, the first protruding portion is provided on each of both the end portions in the circumferential direction of the first core member, and the second protruding portion is provided on each of both the end portions in the circumferential direction of the second core member. In the state in which the magnetic core is transitioned to the closed state and arranged annularly, the first protruding portion on one side of the first core member and the second protruding portion on one side of the second core member overlap each other in the insertion direction, and the first protruding portion on another end side of the first core member and the second protruding portion on another end side of the second core member overlap each other in the insertion direction.

Therefore, the clamp sensor and the measuring device of the present invention can increase a contact area at both ends of the first core member and the second core member compared to a configuration in which the first protruding portion and the second protruding portion are provided only on the one end side of both the core members. In this way, the magnetic coupling force between the first core member and the second core member in the closed state can be sufficiently improved over the entire circumference of the annular magnetic core. In this way, a situation in which a portion having a lower detection sensitivity than other portions is generated at any position in the circumferential direction of the magnetic core can be suitably avoided.

In addition, in the clamp sensor according to the present invention, at least one type of protruding portion selected from the group of the first protruding portion and the second protruding portion is provided as a plurality of protruding portions to be arranged side by side in the insertion direction. A counterpart protruding portion selected from the group of the first protruding portion and the second protruding portion is configured to be inserted between the plurality of protruding portions of the at least one type of protruding portion.

Therefore, according to the clamp sensor and the measuring device according to the present invention, when the clamp sensor, in which the plurality of first protruding portions as the "at least one type of protruding portion" are arranged side by side in the insertion direction of the detection target conductor with respect to the magnetic core, is transitioned from the open state to the closed state by sliding the second case relative to the first case along the virtual straight line, even if foreign matter is adhered between the adjacent first protruding portions of the one end and the other end of the second core member, the foreign matter can be pushed away by the one end and the other end (the second protruding portion: the "counterpart protruding portion") of the second core member and thus eliminated. In addition, when the clamp sensor, in which the plurality of second protruding portions as the "at least one type of protruding portion" are arranged side by side in the insertion direction of the detection target conductor with respect to the magnetic core, is transitioned from the open state to the closed state, even if foreign matter is adhered between the adjacent second protruding portions of the one end and the other end of the second core member, the foreign matter can be pushed away by the one end and the other end (the first protruding portion: the "counterpart protruding portion") of the first core member. In this way, a state in which foreign matter is interposed between the first core member and the second core member in the closed state can be suitably avoided. Furthermore, even if an unintended external force is applied to the first case or the second case in a state in which the detection target is clamped and a small amount of distortion is generated in both the cases, the first core member and the second core member can be maintained in a state of being in contact with each other as a result of the protruding end portion of the first protruding portion coming into contact with the side surface of the second protruding portion and/or the protruding end portion of the second protruding portion coming into contact with the side surface of the first protruding portion. Thus, a state in which a gap is generated in the annular closed magnetic circuit can be suitably avoided. In this way, according to the clamp sensor and the measuring device, the detection amount of the detection target conductor can be detected with high accuracy, and as a result, the measurement amount can be measured with high accuracy.

In addition, in the clamp sensor according to the present invention, at a transition from the closed state to the open state by sliding the second case relative to the first case, the second protruding portion on the one end side is configured to overlap the first protruding portion on the other end side in the insertion direction. In addition, in the clamp sensor according to the present invention, at a transition from the closed state to the open state, and at a transition from the open state to the closed state by sliding the second case relative to the first case, the second protruding portion on the one end side is configured to pass through a position overlapping the first protruding portion on the other end slide in the insertion direction.

Therefore, according to the clamp sensor and the measuring device according to the present invention, the clamp sensor can be transitioned to the open state and then returned to the closed state without causing a situation in which the second protruding portion on the one end side and the first protruding portion on the other end side come into contact with each other and the sliding of the second case relative to the first case is hindered. In this way, when the detection target conductor is inserted inside the first core member (a place surrounded by the first core member), since a portion between both the end portions of the first core member can be completely open, a situation is avoided in which the relative movement of the detection target conductor toward the inside of the first core member is hindered by the second core member. In addition, when the detection target conductor is inserted inside the second core member (a place surrounded by the second core member), since a portion between both the end portions of the second core member can be completely open, a situation is avoided in which the relative movement of the detection target conductor toward the inside of the second core member is hindered by the first core member. Therefore, the detection target conductor can be clamped smoothly.

In addition, the clamp sensor according to the present invention includes a first shield member disposed at an outer circumferential portion of the first core member and accommodated in the first case together with the first core member; and a second shield member disposed at an outer circumferential portion of the second core member and accommodated in the second case together with the second core member. The first shield member is accommodated in the first case to not come into contact with the second core member when the clamp sensor is transitioned from the closed state to the open state, and when the clamp sensor is transitioned from the open state to the closed state. The second shield member is accommodated in the second case to not come into contact with the first core member when the clamp sensor is transitioned from the closed state to the open state, and when the clamp sensor is transitioned from the open state to the closed state. In addition, the clamp sensor according to the present invention includes a first shield member disposed at an outer circumferential portion of the first core member and accommodated in the first case together with the first core member; and a second shield member disposed at an outer circumferential portion of the second core member and accommodated in the second case together with the second core member. The first shield member is accommodated in the first case in a manner that, when the clamp sensor is transitioned from the closed state to the open state, and when the clamp sensor is transitioned from the open state to the closed state, of both of end portions of the first shield member in the circumferential direction, a first end portion located near the first protruding portion on the other end side does not come into contact with the second protruding portion on the other end side. The second shield member is accommodated in the second case in a manner that, when the clamp sensor is transitioned from the closed state to the open state, and when the clamp sensor is transitioned from the open state to the closed state, of both of end portions of the second shield member in the circumferential direction, a second end portion located near the second protruding portion on the one end side does not come into contact with the first protruding portion on the one end side.

Therefore, according to the clamp sensor and the measuring device according to the present invention, a situation can be suitably avoided in which a noise component infiltrates into the magnetic core in the closed state due to the presence of the first shield member and the second shield member, without causing a situation in which the sliding of the second core member relative to the first core member is hindered by the first shield member or the second shield member.

In addition, in the clamp sensor according to the present invention, the first shield member is accommodated in the first case in a manner that, when the clamp sensor is transitioned from the closed state to the open state, and when the clamp sensor is transitioned from the open state to the closed state, the first end portion does not come into contact with the second protruding portion on the one end side. The second shield member is accommodated in the second case in a manner that, when the clamp sensor is transitioned from the closed state to the open state, and when the clamp sensor is transitioned from the open state to the closed state, the second end portion does not come into contact with the first protruding portion on the other end side.

Therefore, according to the clamp sensor and the measuring device according to the present invention, the clamp sensor can be transitioned to the open state and then returned to the closed state without causing a situation in which the first end portion of the first shield member and the second protruding portion on the one end side of the second core member come into contact with each other or the second end portion of the second shield member and the first protruding portion on the other end side of the first core member come into contact with each other, and the sliding of the second case relative to the first case is hindered. In this way, when the detection target conductor is inserted inside the first core member, a situation in which the relative movement of the detection target conductor toward the inside of the first core member is hindered by the second core member and the second shield member is avoided. In addition, when the detection target conductor is inserted inside the second core member, a situation in which the relative movement of the detection target conductor toward the inside of the second core member is hindered by the first core member and the first shield member is avoided. Therefore, the detection target conductor can be clamped smoothly.

In addition, in the clamp sensor according to the present invention, the magnetic core is formed in a manner that a thickness thereof gradually decreases in the insertion direction toward a first direction side, at at least one location, of end portions at two locations including an end portion A and an end portion B. The first direction is a direction of sliding the second case relative to the first case along the virtual straight line when the clamp sensor is transitioned from the closed state to the open state, the end portion A is located to the first direction side at the first protruding portion as at least one type of protruding portion, and the end portion B is located to the first direction side at the second protruding portion as at least one type of protruding portion. In addition, in the clamp sensor according to the present invention, the magnetic core is formed in a manner that a thickness thereof gradually decreases in the insertion direction toward a second direction side, at at least one location, of end portions at two locations including an end portion C and an end portion D. The second direction is a direction of sliding the second case relative to the first case along the virtual straight line when the clamp sensor is transitioned from the open state to the closed state. The end portion C is located to the second direction side at the first protruding portion as at least one type of protruding portion, and the end portion D is located to the second direction side at the second protruding portion as at least one type of protruding portion.

Therefore, according to the clamp sensor and the measuring device according to the present invention, when the clamp sensor is transitioned from the closed state to the open state and transitioned from the open state to the closed state, even if the first protruding portion and the second protruding portion are slightly misaligned in the insertion direction, the first protruding portion and the second protruding portion are unlikely to come into contact with each other in the sliding direction. Thus, the second case can be suitably slid with respect to the first case.

### ADVANTAGEOUS EFFECTS OF INVENTION

According to the clamp sensor and the measuring device of the present invention, the contact area between the first core member and the second core member in the closed state can be increased, and even if the magnetic core is reduced in size, the first core member and the second core member can be coupled with a sufficient magnetic coupling force in the closed state. As a result, the clamp sensor can be further reduced in size and the detection target conductor can be reliably and easily clamped even in a narrow place. The sensitivity of the clamp sensor can thus be further improved.

### BRIEF DESCRIPTION OF DRAWINGS

FIG. 1 is a configuration diagram illustrating a configuration of a measuring device 1.
FIG. 2 is an external perspective view of a clamp sensor 3 in a closed state.
FIG. 3 is an external perspective view of the clamp sensor 3 in an open state.
FIG. 4 is a side view of a tip end portion side of the clamp sensor 3 in the closed state.
FIG. 5 is an explanatory view for explaining a first case 11, a first core member 21, and a first shield member 41.
FIG. 6 is an explanatory view for explaining a second case 12, a second core member 22, and a second shield member 42.
FIG. 7 is a side view of a standalone magnetic core 20.
FIG. 8 is a front view of the standalone magnetic core 20.
FIG. 9 is an exploded perspective view of the standalone magnetic core 20.
FIG. 10 is an explanatory view for explaining shapes of tip ends P21a and P21b of a plate 25a in first core members 21a and 21b.
FIG. 11 is an explanatory view for explaining shapes of tip ends P22a and P22b of a plate 26a in a second core member 22.
FIG. 12 is an external perspective view of a shield 40 and the magnetic core 20 in a closed state.
FIG. 13 is an external perspective view of the shield 40 and the magnetic core 20 in an open state.
FIG. 14 is an external perspective view of the standalone magnetic core 20 in the closed state.
FIG. 15 is an external perspective view of the standalone magnetic core 20 at a transition from the closed state to the open state and a transition from the open state to the closed state.
FIG. 16 is an explanatory view for explaining a positional relationship between the first core members 21a and 21b and the second core member 22 of the clamp sensor 3 in the open state, and a first shield member 41 and a second shield member 42.
FIG. 17 is an explanatory view for explaining a positional relationship between the first core members 21a and 21b and the second core member 22 of the clamp sensor 3 in the closed state, and the first shield member 41 and the second shield member 42.
FIG. 18 is an explanatory view for explaining a positional relationship between the first core member 21 (plate 25a) and the second core member 22 (plate 26a) when opening and closing the clamp sensor 3.
FIG. 19 is an explanatory view for explaining a positional relationship between the first core member 21 (plate 25a) and the second core member 22 (plate 26a) when the clamp sensor 3 is transitioned to the closed state.
FIG. 20 is an explanatory view for explaining a positional relationship between the first core member 21 (plate 25a) and the second core member 22 (plate 26a) when opening and closing the clamp sensor 3 according to another embodiment.
FIG. 21 is an explanatory view for explaining a positional relationship between the first core member 21 (plate 25a) and the second core member 22 (plate 26a) when the clamp sensor 3 according to the other embodiment is transitioned to the closed state.
FIG. 22 is an explanatory view for explaining a positional relationship between tip ends P41a and P41b of a first shield member 41a and tip ends P42a and P42b of a second shield member 42a when a clamp sensor 3A according to another embodiment is transitioned to the open state.
FIG. 23 is an explanatory view for explaining a positional relationship between the tip ends P41a and P41b of the first shield member 41a and the tip ends P42a and P42b of the second shield member 42a when the clamp sensor 3A according to the other embodiment is transitioned to the closed state.
FIG. 24 is an explanatory view for explaining a relative sliding direction of a second case 12 with respect to a first case 11.
FIG. 25 is another explanatory view for explaining the relative sliding direction of the second case 12 with respect to the first case 11.
FIG. 26 is an explanatory view for explaining a positional relationship between the first core member 21 and the second core member 22 of the clamp sensor 3, and the first shield member 41 and the second shield member 42 at the transition from the closed state to the open state, and at the transition from the open state to the closed state.
FIG. 27 is an external perspective view of the standalone magnetic core 20 in the closed state in a configuration according to the other embodiment.
FIG. 28 is a side view of a clamp sensor 3B according to the other embodiment in the closed state.
In FIG. 29, a left diagram is a front view of a standalone magnetic core 20C in a clamp sensor 3C according to another embodiment, and a right diagram is a front view of a standalone magnetic core 20D in a clamp sensor 3D.

### DESCRIPTION OF EMBODIMENTS

Hereinafter, embodiments of a clamp sensor and a measuring device will be described with reference to the accompanying drawings.

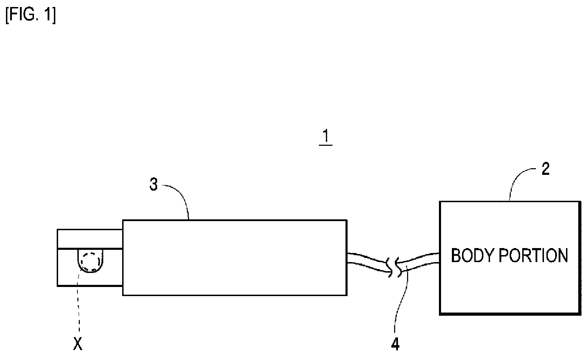

A measuring device 1 illustrated in FIG. 1 is an example of a "measuring device" and is configured to include a body portion 2 and a clamp sensor 3. In the body portion 2, a "measuring unit (measuring circuit)" for measuring a measurement amount of a measurement target conducting wire X, which is an example of a "detection target conductor", based on a detection amount by the clamp sensor 3, and the like are accommodated inside a housing, and an operation interface provided with various operation switches, a display unit for displaying a measured value and the like (both of which are not illustrated) are also disposed therein. The clamp sensor 3 is connected to the body portion 2 via a cable 4.

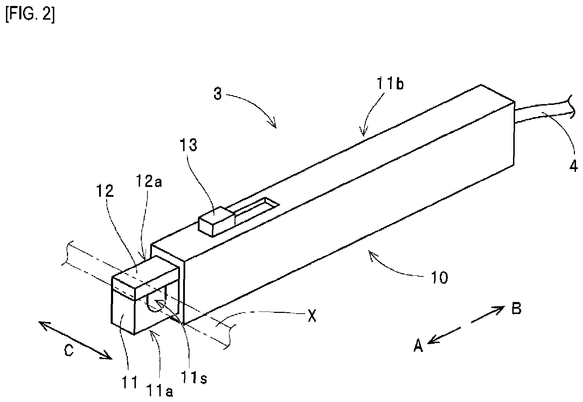

In contrast, the clamp sensor 3 is an example of a "clamp sensor", and as illustrated in FIGS. 2 to 6, includes a casing 10, a magnetic core 20, a magnetic detection element 30, a shield 40, a winding 50, and the like.

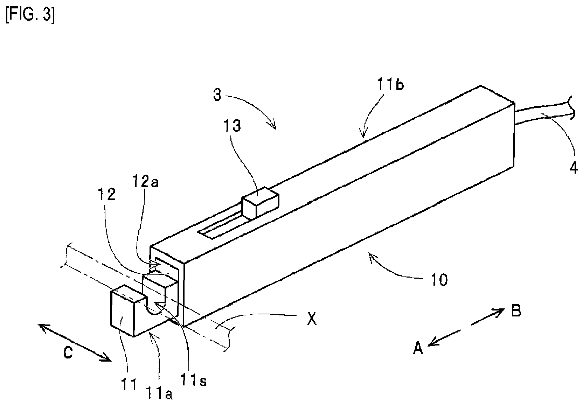

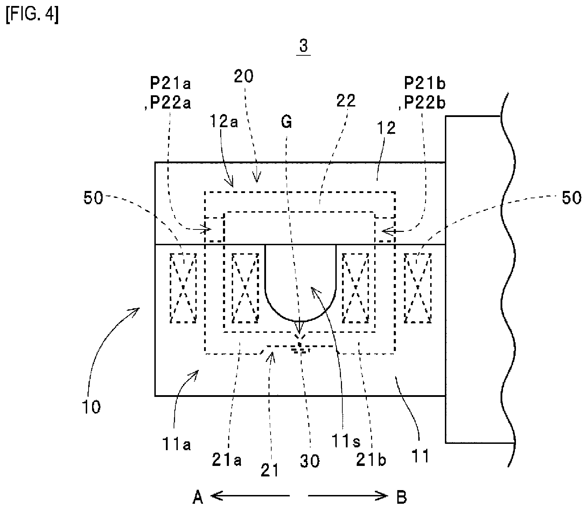

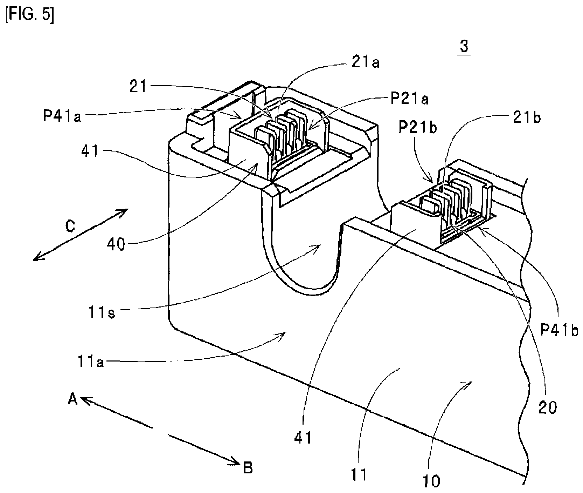

The casing 10 includes a first case 11 and a second case 12, and is configured to accommodate the magnetic core 20, the magnetic detection element 30, the shield 40, the winding 50, and the like. The first case 11 is an example of a "first case", and as illustrated in FIGS. 2 and 3, an accommodating portion 11a and a gripping portion 11b are arranged side by side along the directions of arrows A and B. As illustrated in FIGS. 4 and 5, the accommodating portion 11a is provided with a notch 11s through which the measurement target conducting wire X can be inserted, and is configured to accommodate a first core member 21 (described later) of the magnetic core 20, the magnetic detection element 30, a first shield member 41 (described later) of the shield 40, the winding 50, and the like.

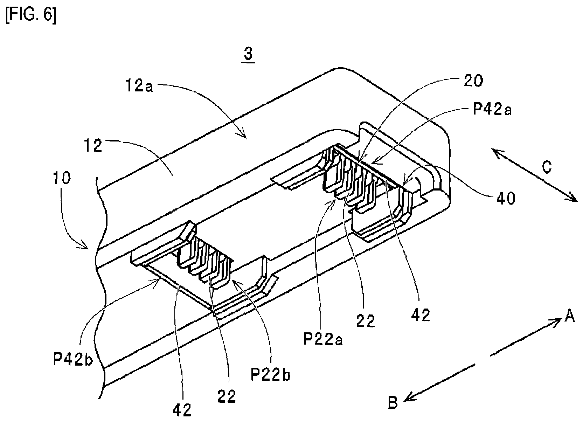

The second case 12 is an example of a "second case", and as illustrated in FIGS. 2 and 3, includes an accommodating portion 12a. The second case 12 is provided with an operating knob 13 for sliding the second case 12 in the directions of the arrows A and B with respect to the first case 11, and is configured in a manner that the second case 12 can slide relative to the first case 11 in the directions of the arrows A and B (slide along a "virtual straight line" described later). As illustrated in FIGS. 4 and 6, the accommodating portion 12a is configured to accommodate a second core member 22 (described later) of the magnetic core 20, a second shield member 42 (described later) of the shield 40, and the like.

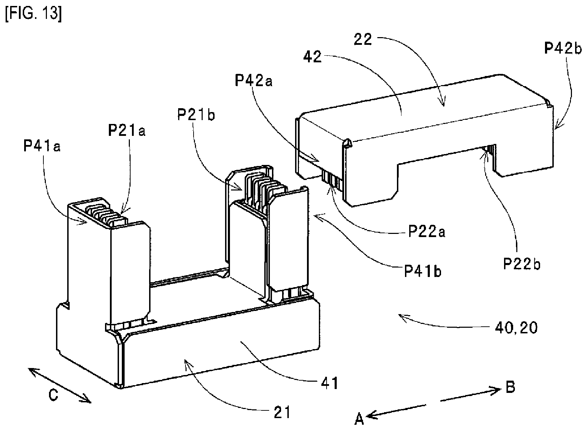

The magnetic core 20 is a closed magnetic circuit constituent member having a comb-tooth junction structure, which is an example of a "magnetic core arranged annularly in a closed state", and as illustrated in FIGS. 4, 7 to 9, and 12 to 15, includes the first core member 21 and the second core member 22, and is configured to form an annular closed magnetic circuit having a rectangular shape in a side view in the closed state. The first core member 21 is an example of a "first core member constituting a part of the magnetic core in the circumferential direction", and as illustrated in FIG. 4, is accommodated in the accommodating portion 11a of the first case 11 in a manner that a gap G is formed at the central portion in the longitudinal direction thereof. Hereinafter, of two members constituting the first core member 21, the member arranged on the tip end side is also referred to as a first core member 21a. In addition, the member arranged on the gripping portion 11b side is also referred to as a first core member 21b (an example in which the "first core member" is constituted by two members).

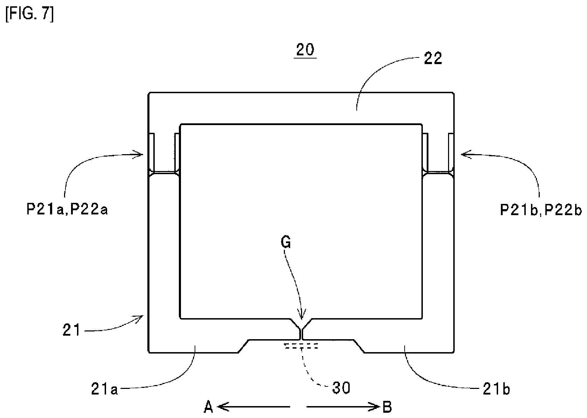

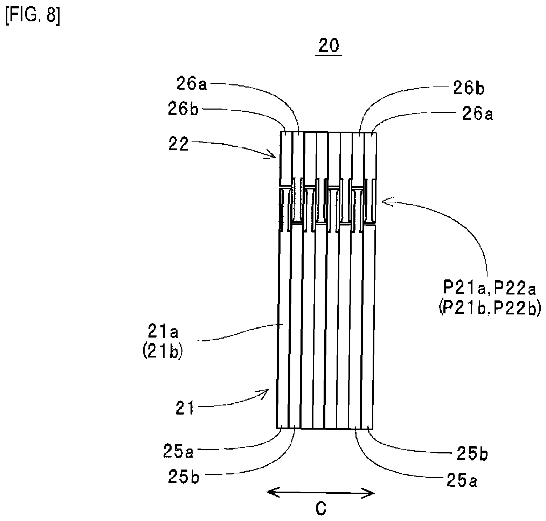

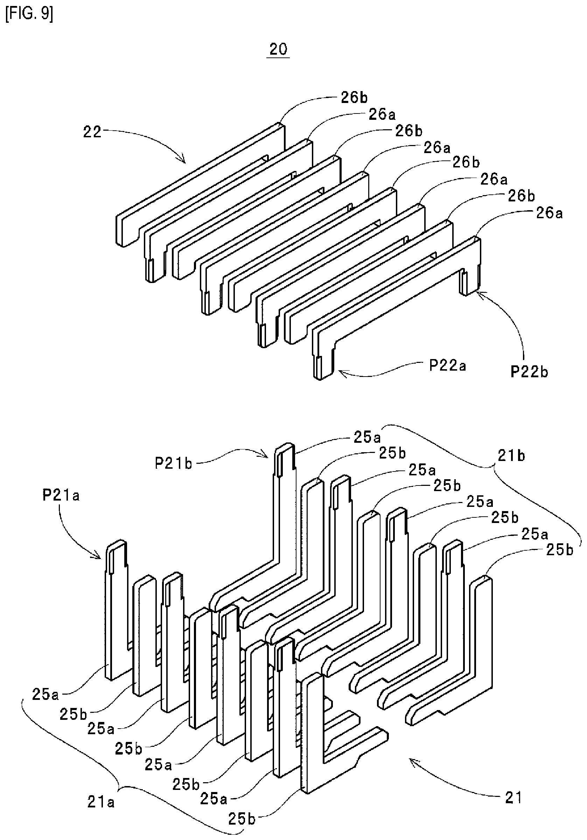

As illustrated in FIG. 9, the first core members 21a and 21b are each formed in a substantially L-shape in a side view as illustrated in FIG. 7, by alternately stacking plates 25a and 25b. In this case, as illustrated in FIGS. 8 and 9, in the clamp sensor 3 of the present example, the plate 25a is formed to be longer than the plate 25b, and both the plates 25a and 25b are stacked in a manner that the tip end of the plate 25a protrudes from the tip end of the plate 25b, whereby the tip end of the plate 25a (a portion on tip ends P21a and P21b side of the plate 25a: hereinafter, also referred to as the tip end P21a of the plate 25a or the tip end P21b of the plate 25a) constitutes a "first protruding portion protruding along the circumferential direction of the annular magnetic core".

Note that, in the clamp sensor 3 of the present example, the plate 25a of the first core member 21a and the plate 25a of the first core member 21b are constituted by the same product (the same member). In addition, in the clamp sensor 3 of the present example, the plate 25b of the first core member 21a and the plate 25b of the first core member 21b are constituted by the same product (the same member). In this way, both the first core members 21a and 21b can be manufactured by producing one type of the plate 25a and one type of the plate 25b.

In this case, in the clamp sensor 3 of the present example, the tip end P21a of the first core member 21 (see FIGS. 4, 5, 7 to 9, and 12 to 15) corresponds to "one end of the first core member". In addition, in the clamp sensor 3 of the present example, the tip end P21b of the first core member 21 (see FIGS. 4, 5, 7 to 9 and 12 to 15) corresponds to "another end of the first core member". In addition, in the clamp sensor 3 of the present example, as an example, the first core members 21a and 21b are each formed by four of the plates 25a and four of the plates 25b. That is, in the clamp sensor 3 of the present example, four of the "first protruding portions" are provided at the tip end P21a of the first core member 21, and four of the "first protruding portions" are provided at the tip end P21b of the first core member 21 (an example of a configuration in which a plurality of the "first protruding portions" as the "at least one type of protruding portion" are provided so as to be arranged side by side in an "insertion direction of the detection target conductor with respect to the magnetic core"). In this case, in the magnetic core 20 of the present example, the first core member 21 is constituted in a manner that the tip ends P21a and P21b overlap each other in a relative sliding direction (directions of the arrows A and B in each of the drawings) of the second case 12 with respect to the first case 11.

The second core member 22 is an example of a "second core member formed separately from the first core member and constituting another part of the magnetic core in the circumferential direction", and as illustrated in FIG. 9, each of the second core members 22 is formed in a substantially U-shape in a side view by alternately stacking plates 26a and 26b. In this case, in the clamp sensor 3 of the present example, the plate 26a is formed to be longer than the plate 26b, and both the plates 26a and 26b are stacked in a manner that the tip end of the plate 26a protrudes from the tip end of the plate 26b, whereby the tip end of the plate 26a (a portion on tip ends P22a and P22b side of the plate 26a: hereinafter, also referred to as the tip end P22a of the plate 26a or the tip end P22b of the plate 26a) constitutes a "second protruding portion protruding along the circumferential direction of the annular magnetic core".

Note that, in the clamp sensor 3 of the present example, the tip end P22a of the second core member 22 (see FIGS. 4, 6 to 9, and 12 to 15) corresponds to "one end of the second core member". In addition, in the clamp sensor 3 of the present example, the tip end P22b of the second core member 22 (see FIGS. 4, 6 to 9, and 12 to 15) corresponds to "another end of the second core member". In this case, in the clamp sensor 3 of the present example, as an example, the second core member 22 is formed by four of the plates 26a and four of the plates 26b. That is, in the clamp sensor 3 of the present example, four of the "second protruding portions" are provided at the tip end P22a of the second core member 22, and four of the "second protruding portions" are provided at the tip end P22b of the second core member 22 (an example of a configuration in which a plurality of the "second protruding portions" as the "at least one type of protruding portion" are provided so as to be arranged side by side in the "insertion direction of the detection target conductor with respect to the magnetic core"). In this case, in the magnetic core 20 of the present example, the second core member 22 is configured in a manner that the tip ends P22a and P22b overlap each other in the relative sliding direction (directions of the arrows A and B in each of the drawings) of the second case 12 with respect to the first case 11.

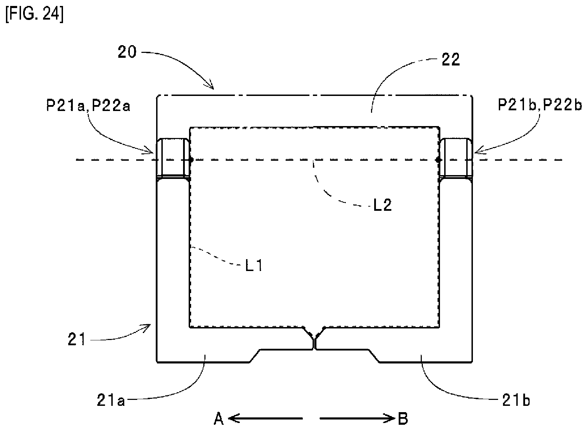

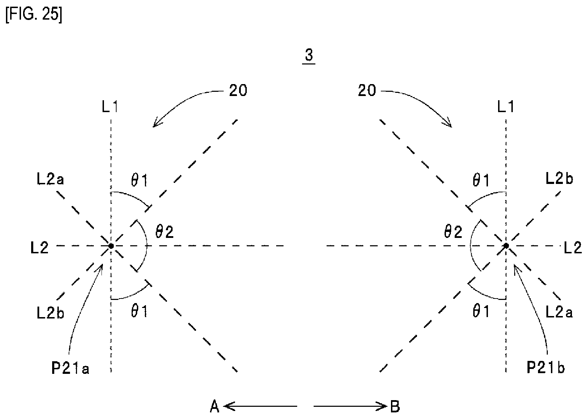

In this case, as illustrated in FIGS. 24 and 25, in the clamp sensor 3 of the present example, when the magnetic core 20 that is transitioned to the closed state and arranged annularly is viewed along the insertion direction of the measurement target conducting wire X with respect to the magnetic core 20, the second case 12 is configured to be slidable relative to the first core member 21 as indicated by the arrows A and B along the "virtual straight line (a rough dashed line L2 in both drawings)" intersecting an inner circumferential side edge portion of the magnetic core 20 (a portion indicated by a dashed line L1 in both drawings) at either one of both end portions in the circumferential direction of the first core member 21 (in this example, at both the tip ends P21a and P21b).

Note that an "[intersection angle with respect to the inner circumferential side edge portion] of the [virtual straight line] intersecting the inner circumferential side edge portion of the magnetic core at either one of both the end portions in the circumferential direction of the first core member" is not limited to 90° (orthogonal) in the example of the clamp sensor 3 of the present example. However, when a configuration in which sliding is performed along the "virtual straight line" in which the "intersection angle" is excessively small is adopted, there is a possibility that the "effect achieved by the effect of the present invention" described later is not sufficiently achieved. Therefore, it is preferable that a configuration be adopted in which the sliding can be performed along the "virtual straight line" in a manner that an intersection angle θ1 with respect to the "inner circumferential side edge portion (dashed line L1) of the magnetic core" is an angle within an angle range θ2 of at least 45°, like the "virtual straight lines" indicated by rough dashed lines L2a and L2b illustrated in FIG. 25.

In addition, in the magnetic core 20 of the clamp sensor 3 of the present example, the dashed line L1, which is the "inner circumferential side edge portion of the magnetic core 20", has portions parallel to each other at the tip ends P21a and P21b of the first core member 21. Therefore, the rough dashed line L2, which is an example of the "virtual straight line", intersects (in this example, is orthogonal to) the dashed line L1 at the same intersection angle at both the tip ends P21a and P21b of the first core member 21. However, unlike the magnetic core 20 of the present example, when a magnetic core (not illustrated) is provided in which the "inner circumferential side edge portion of the magnetic core" is not parallel to the "one end portion and the other end portion of the first core member", the "second case" can be configured to be slidable relative to the "first case" along the "virtual straight line" intersecting the "inner circumferential side edge portion of the magnetic core" at either one of the "one end portion of the first core member" or the "other end portion of the first core member".

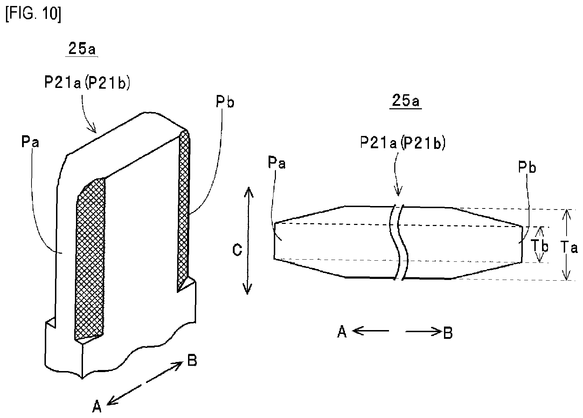

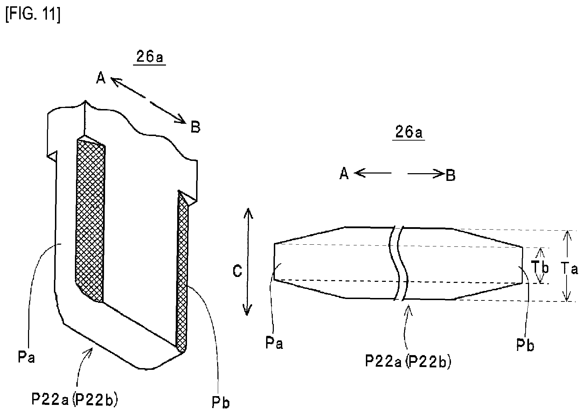

In addition, as illustrated in FIGS. 10 and 11, in the clamp sensor 3 of the present example, a thickness in the "insertion direction (direction of an arrow C)" of the measurement target conducting wire X with respect to the clamp sensor 3 gradually decreases toward a "first direction" side, at both of two locations, that is, at an end portion Pb (an example of an "end portion A") located on the "first direction (direction of the arrow B)" side and at an end portion Pb (an example of an "end portion B") located on the "first direction (direction of the arrow B)" side of each of the "second protruding portions (both the tip ends P22a and P22b of the plate 26a)" of the second core member 22. The "first direction" is the direction of the relative sliding of the second case 12 with respect to the first case 11 when the clamp sensor 3 is transitioned from the closed state to the open state in each of the "first protruding portions (both the tip ends P21a and P21b of the plate 25a)" of the first core member 21. Specifically, in each of the "first protruding portions" of the first core member 21, the thickness of the central portion in the sliding direction (direction of the arrows A and B) is a thickness Ta, whereas the thickness of the end portion Pb is a thickness Tb which is thinner than the thickness Ta. In addition, in each of the "second protruding portions" of the second core member 22, the thickness of the central portion in the sliding direction (direction of the arrows A and B) is the thickness Ta, whereas the thickness of the end portion Pb is the thickness Tb which is thinner than the thickness Ta.

In addition, in the clamp sensor 3 of the present example, a thickness in the "insertion direction (direction of the arrow C)" of the measurement target conducting wire X with respect to the clamp sensor 3 gradually decreases toward the "second direction" side at both of two locations, that is, at an end portion Pa (an example of an "end portion C") located on a "second direction (direction of the arrow A)" side and at an end portion Pa (an example of an "end portion D") located on the "second direction (direction of the arrow A)" side of each of the "second protruding portions" of the second core member 22. The "second direction" is the direction of the relative sliding of the second case 12 with respect to the first case 11 when the clamp sensor 3 is transitioned from the open state to the closed state in each of the "first protruding portions" of the first core member 21. Specifically, in each of the "first protruding portions" of the first core member 21, the thickness of the central portion in the sliding direction (direction of the arrows A and B) is the thickness Ta, whereas the thickness of the end portion Pa is the thickness Tb which is thinner than the thickness Ta. In addition, in each of the "second protruding portions" of the second core member 22, the thickness of the central portion in the sliding direction (direction of the arrows A and B) is the thickness Ta, whereas the thickness of the end portion Pa is the thickness Tb which is thinner than the thickness Ta.

In addition, as illustrated in FIGS. 4 and 7, in the clamp sensor 3 of the present example, the magnetic detection element 30 is accommodated in the accommodating portion 11a of the first case 11 so as to be arranged near the gap G provided between the first core members 21a and 21b.

On the other hand, as illustrated in FIGS. 5, 6, 12 and 13, the shield 40 includes the first shield member 41 and the second shield member 42. The first shield member 41 is an example of a "first shield member", and as illustrated in FIGS. 5, 12 and 13, is accommodated in the accommodating portion 11a of the first case 11 together with the first core member 21 in a state in which the first shield member 41 is arranged at an outer circumferential portion of the first core member 21. The second shield member 42 is an example of a "second shield member", and as illustrated in FIGS. 6, 12 and 13, is accommodated in the accommodating portion 12a of the second case 12 together with the second core member 22 in a state in which the second shield member 42 is arranged at an outer circumferential portion of the second core member 22.

Note that, in the clamp sensor 3 of the present example, a tip end P41a (see FIGS. 5, 12 and 13) of the first shield member 41 corresponds to "one end of the first shield member". In addition, a tip end P41b (see FIGS. 5, 12 and 13) of the first shield member 41 corresponds to "another end of the first shield member". In addition, in the clamp sensor 3 of the present example, a tip end P42a (see FIGS. 6, 12 and 13) of the second shield member 42 corresponds to "one end of the second shield member". In addition, a tip end P42b (see FIGS. 6, 12 and 13) of the second shield member 42 corresponds to "another end of the second shield member".

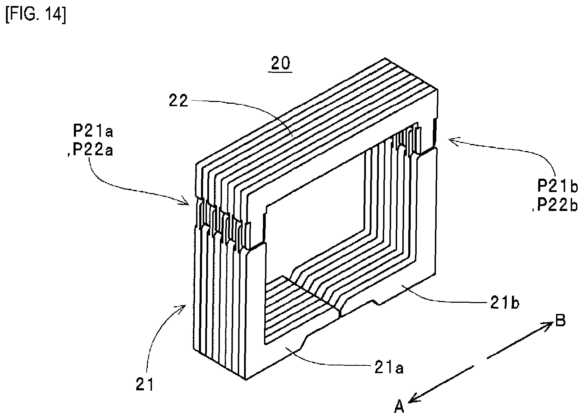

As illustrated in FIGS. 4 and 14, in the clamp sensor 3, in a state in which the magnetic core 20 is transitioned to the closed state and arranged annularly, the "first protruding portion (plate 25a)" on the tip end P21a side of the first core member 21 and the "second protruding portion (plate 26a)" on the tip end P22a side of the second core member 22 are configured to overlap each other in the insertion direction (direction of the arrow C illustrated in FIGS. 2, 3 and the like) of the measurement target conducting wire X with respect to the magnetic core 20 (an example of a configuration in which the "second protruding portion" as the "counterpart protruding portion" is interposed between the "first protruding portions" as the "at least one type of protruding portion"). In addition, the "first protruding portion (plate 25a)" on the tip end P21b side of the first core member 21 and the "second protruding portion (plate 26a)" on the tip end P22b side of the second core member 22 are configured to overlap each other in the insertion direction of the measurement target conducting wire X with respect to the magnetic core 20 (an example of a configuration in which the "first protruding portion" as the "counterpart protruding portion" is interposed between the "second protruding portions" as the "at least one type of protruding portion").

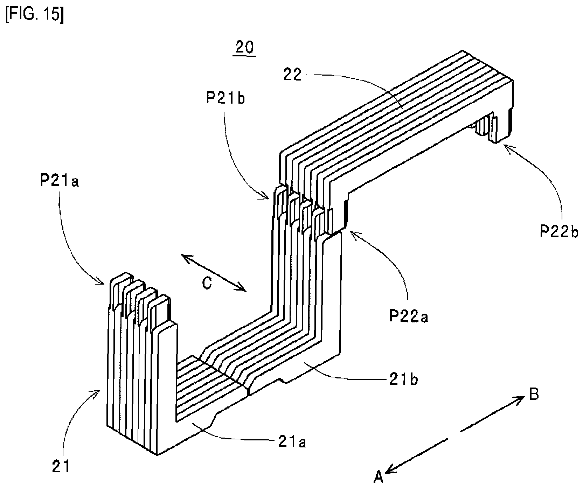

**In** addition, as illustrated in FIG. 15, in the clamp sensor 3, at a transition from the closed state to the open state and at a transition from the open state to the closed state by sliding the second case 12 relative to the first case 11, the "second protruding portion (plate 26a)" on the tip end P22a side of the second core member 22 is configured to pass through a position at which the "second protruding portion (plate 26a)" overlaps the "first protruding portion (plate 25a)" on the tip end P21b side of the first core member 21 in the insertion direction of the measurement target conducting wire X with respect to the magnetic core 20.

Specifically, as illustrated in FIG. 8, in the clamp sensor 3 of the present example, when the magnetic core 20 is viewed along the directions of the arrows A and B illustrated in FIGS. 2 to 7, the plates 26b at the second core member 22 are stacked at stacking positions (the positions of the plates 25a in the insertion direction: positions in the direction of the arrow C) at which the plates 25a are stacked at the first core member 21, namely, at the positions of the "first protruding portions" in the insertion direction. **In** addition, in the clamp sensor 3 of the present example, the plates 26a at the second core member 22 are stacked at stacking positions (the positions of the plates 25b in the insertion direction: positions in the direction of the arrow C) at which the plates 25b are stacked at the first core member 21, namely, at the positions between the two "first protruding portions" adjacent to each other in the "insertion direction".

In addition, in the clamp sensor 3 of the present example, the plates 25b at the first core member 21 are stacked at stacking positions (the positions of the plates 26a in the insertion direction: positions in the direction of the arrow C) at which the plates 26a are stacked at the second core member 22, namely, at the positions of the "second protruding portions" in the insertion direction. In addition, in the clamp sensor 3 of the present example, the plates 25a at the first core member 21 are stacked at stacking positions (the positions of the plates 26b in the insertion direction: positions in the direction of the arrow C) at which the plates 26b are stacked at the second core member 22, namely, at the positions between the two "second protruding portions" adjacent to each other in the "insertion direction".

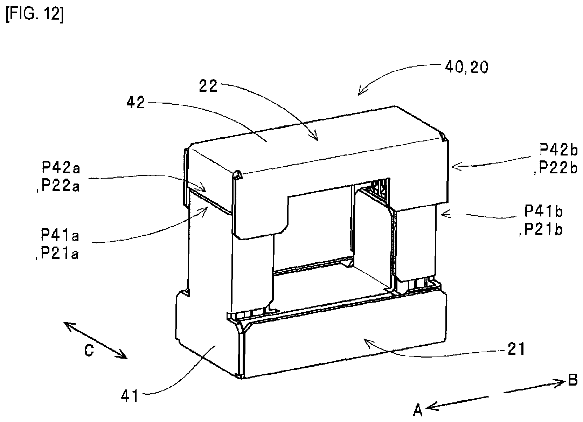

In addition, as illustrated in FIGS. 12, 13, 16, 17 and 26, in the clamp sensor 3 of the present example, the first shield member 41 is configured in a manner that a "first end portion (tip end P41b)" of the first shield member 41 does not come into contact with the "second protruding portion on another end side (tip end P22b of the plate 26a)" and the "second protruding portion on one end side (tip end P22a of the plate 26a)" at a transition from the closed state to the open state and at a transition from the open state to the closed state by sliding the second case 12 relative to the first case 11, and the first shield member 41 is accommodated in the accommodating portion 11a of the first case 11.

In addition, in the clamp sensor 3 of the present example, the second shield member 42 is configured in a manner that a "second end portion (tip end P42a)" of the second shield member 42 does not come into contact with the "first protruding portion on the one end side (tip end P21a of the plate 25a)" and the "first protruding portion on the other end side (tip end P21b of the plate 25a)" at a transition from the closed state to the open state and at a transition from the open state to the closed state by sliding the second case 12 relative to the first case 11, and the second shield member 42 is accommodated in the accommodating portion 12a of the second case 12.

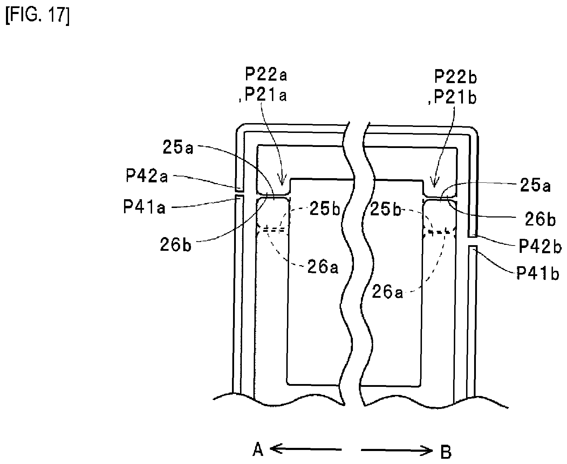

Further, as illustrated in FIGS. 12 and 17, in the clamp sensor 3 of the present example, in a state in which the first core member 21 and the second core member 22 are transitioned to the closed state and arranged annularly, the first shield member 41 and the second shield member 42 are configured in a manner that the tip end P41a of the first shield member 41 and the tip end P42a of the second shield member 42 are arranged extremely close to each other and the tip end P41b of the first shield member 41 and the tip end P42b of the second shield member 42 are arranged extremely close to each other.

Next, an example of the usage method of the measuring device 1 will be described with reference to the accompanying drawings.

When measuring the measurement amount of the measurement target conducting wire X by the measuring device 1, the measurement target conducting wire X is first clamped by the clamp sensor 3. At this time, as an example, by placing, on the operating knob 13, the thumb of the hand gripping the gripping portion 11b and pulling the operating knob 13 in the direction of the arrow B, as illustrated in FIG. 3, the second case 12 is slid with respect to the first case 11 in the direction of the arrow B (an example of the direction along the rough dashed line L2 which is an example of the "virtual straight line" described above) so as to retract the second case 12 from above the accommodating portion 11a and cause the transition to the open state in which the notch 11s is opened.

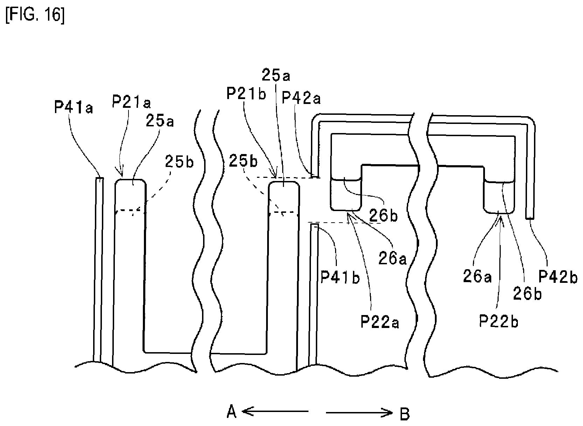

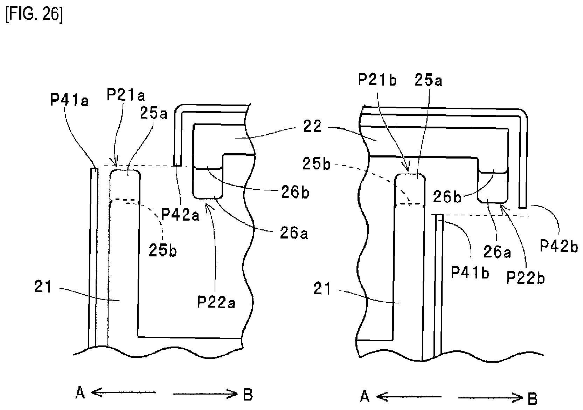

At this time, as illustrated in FIGS. 16 and 26, in the clamp sensor 3 of the present example, at a transition from the closed state to the open state, the second shield member 42 is configured in a manner that the tip end P42a of the second shield member 42 does not come into contact with the "first protruding portion (plate 25a)" on the tip end P21a side and the "first protruding portion (plate 25a)" on the tip end P21b side of the first core member 21. In addition, as illustrated in FIG. 15, in the clamp sensor 3 of the present example, at a transition from the closed state to the open state, the "second protruding portion (plate 26a)" on the tip end P22a side of the second core member 22 is configured to pass through the position overlapping the "first protruding portion (plate 25a)" on the tip end P21b side of the first core member 21 in the insertion direction (direction of the arrow C) of the measurement target conducting wire X with respect to the magnetic core 20.

Therefore, in the clamp sensor 3 of the present example, the second case 12 can be smoothly slid in the direction of the arrow B with respect to the first case 11 without causing the tip end P42a of the second shield member 42 and the tip end P22a of the second core member 22 to be caught by the tip ends P21a and P21b of the first core member 21. In addition, since the tip end P42a of the second shield member 42 and the tip end P22a of the second core member 22 can be slid closer to the gripping portion 11b side than the tip end P21b of the first core member 21, the entire notch 11s can be sufficiently opened.

In this case, as described above, in the clamp sensor 3 of the present example, in each of the "second protruding portions" of the second core member 22, the thickness along the "insertion direction (direction of the arrow C)" of the measurement target conducting wire X of the end portion Pb located on the "first direction (direction of the arrow B)" side gradually decreases toward the "first direction" side. Therefore, even in a state in which the first core member 21 and the second core member 22 are slightly misaligned in the "insertion direction" at a transition from the closed state to the open state, the end portion Pb of each of the "second protruding portions" can be smoothly inserted between the corresponding "first protruding portions" in a manner that each of the "second protruding portions" can smoothly pass by the "first protruding portions".

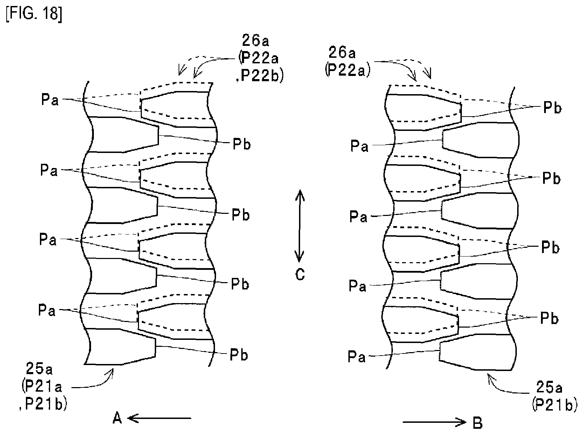

Specifically, as illustrated in the right diagram of FIG. 18, when the second case 12 is slid in the direction of the arrow B with respect to the first case 11 at a transition from the closed state to the open state, as an example, the "second protruding portion (the tip end P22a of the plate 26a)" which should be present at the position indicated by the dashed line with respect to the "first protruding portion (the tip end P21b of the plate 25a)" may be misaligned in the "insertion direction (direction of the arrow C: downward in this example)" and may be present at the position indicated by the solid line. At this time, in the clamp sensor 3 of the present example, the second core member 22 is formed in a manner that the end portion Pb of the tip end P22a of the plate 26a becomes gradually thinner in the direction of the arrow B, and the first core member 21 is formed in a manner that the end portion Pa of the tip end P21b of the plate 25a becomes gradually thinner in the direction of the arrow A opposite to the direction of the arrow B.

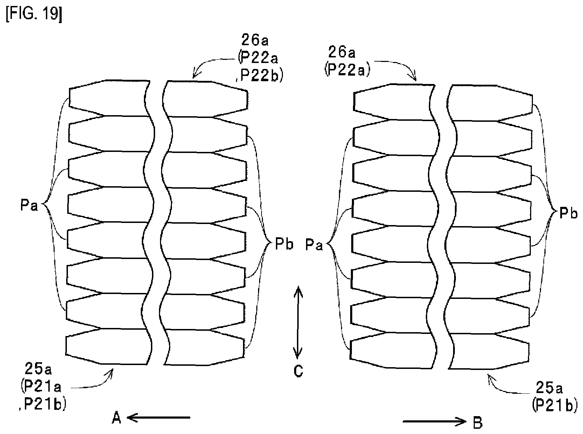

Therefore, when the second case 12 is further moved in the direction of the arrow B in the state in which the "second protruding portion" is misaligned with respect to the "first protruding portion" as described above, the foremost tip end (right end in the drawing) of the end portion Pb of the "second protruding portion" is unlikely to come into contact with the foremost tip end (left end in the drawing) of the end portion Pa of the "first protruding portion", and each of the "second protruding portions" can be smoothly inserted between the corresponding "first protruding portions". Therefore, by moving the second case 12 further in the direction of the arrow B, as illustrated in the right diagram of FIG. 19, each of the "second protruding portions" is smoothly moved in the direction of the arrow B with respect to the corresponding "first protruding portions" after going through a state in which each of the "first protruding portions" and the corresponding one of the "second protruding portions" overlap in the direction of the arrow C. In this way, as indicated by an alternate long and short dash line in FIG. 3, the measurement target conducting wire X can be reliably and easily inserted into the notch 11s of the first case 11 in the clamp sensor 3 that has transitioned to the open state.

Note that, although it is different from the configuration of the clamp sensor 3 of the present example, a configuration may be adopted in which the "first case" is slid with respect to the "second case" at a transition from the closed state to the open state. In such a case, when in each of the "first protruding portions" of the "first core member", the thickness along the "insertion direction" of the "end portion A" located on the "first direction" side gradually decreases toward the "first direction" side, the same effect as the clamp sensor 3 of the present example can be achieved.

Subsequently, as illustrated in FIG. 2, the second case 12 is slid with respect to the first case 11 in the direction of the arrow A (another example of the direction along the rough dashed line L2 which is an example of the "virtual straight line" described above) to cause the transition to the closed state. At this time, as illustrated in FIG. 15, the clamp sensor 3 of the present example is configured in a manner that, even at a transition from the open state to the closed state, the "second protruding portion (plate 26a)" on the tip end P22a side of the second core member 22 can pass through the position overlapping the "first protruding portion (plate 25a)" on the tip end P21b side of the first core member 21 in the insertion direction of the measurement target conducting wire X with respect to the magnetic core 20. In addition, as illustrated in FIGS. 16 and 26, in the clamp sensor 3 of the present example, the second shield member 42 is configured in a manner that, even at a transition from the open state to the closed state, the tip end P42a of the second shield member 42 does not come into contact with the "first protruding portion (plate 25a)" on the tip end P21b side and the "first protruding portion (plate 25a)" on the tip end P21a side of the first core member 21.

Therefore, in the clamp sensor 3 of the present example, the second case 12 can be smoothly slid in the direction of the arrow A with respect to the first case 11 without causing the tip end P42a of the second shield member 42 and the tip end P22a of the second core member 22 to be caught by the tip ends P21b and P21a of the first core member 21.

In this case, in the clamp sensor 3 of the present example, at a transition from the open state to the closed state as described above, the "second protruding portion (plate 26a)" on the tip end P22a side of the second core member 22 is inserted between the adjacent "first protruding portions (plates 25a)" on the tip end P21a side after passing between the adjacent "first protruding portions (plates 25a)" on the tip end P21b side of the first core member 21. In addition, the "second protruding portion (plate 26a)" on the tip end P22b side of the second core member 22 is inserted between the adjacent "first protruding portions (plates 25a)" on the tip end P21b side of the first core member 21. In other words, at a transition from the open state to the closed state, the "first protruding portion (plate 25a)" on the tip end P21b side of the first core member 21 is relatively passed between the adjacent "second protruding portions (plates 26a)" on the tip end P22a side of the second core member 22. After that, the "first protruding portion (plate 25a)" on the tip end P21a side is relatively inserted between the adjacent "second protruding portions (plates 26a)" on the tip end P22a side, and the "first protruding portion (plate 25a)" on the tip end P21b side of the first core member 21 is relatively inserted between the adjacent "second protruding portions (plates 26a)" on the tip end P22b side of the second core member 22.

Therefore, even if foreign matter adheres to the tip ends P21a and P21b of the first core member 21, the foreign matter is pushed away from the tip ends P21a and P21b by the plate 26a of the second core member 22, and even if foreign matter adheres to the tip ends P22a and P22b of the second core member 22, the foreign matter is pushed away from the tip ends P22a and P22b by the plate 25a of the first core member 21. In this way, a state in which foreign matter is interposed between the first core member 21 and the second core member 22 in the closed state can be suitably avoided.

In this case, as described above, in the clamp sensor 3 of the present example, in each of the "first protruding portions" of the first core member 21, the thickness along the "insertion direction (direction of the arrow C)" of the end portion Pb located on the "first direction (direction of the arrow B)" side gradually decreases toward the "first direction" side. In addition, in the clamp sensor 3 of the present example, in each of the "second protruding portion" of the second core member 22, the thickness along the "insertion direction (direction of the arrow C)" of the end portion Pa located on the "second direction (direction of the arrow A)" side gradually decreases toward the "second direction" side. Therefore, even if the first core member 21 and the second core member 22 are slightly misaligned in the insertion direction at a transition to the closed state, the end portion Pa of each of the "second protruding portions" can be smoothly inserted between the corresponding "first protruding portions" (the end portion Pb of each of the "second protruding portions" can be smoothly inserted between the corresponding "second protruding portions") in a manner that each of the "first protruding portions" and the corresponding one of the "second protruding portions" are reliably brought into a state of overlapping in the "insertion direction".

Specifically, as illustrated in the left diagram of FIG. 18, when the second case 12 is slid in the direction of the arrow A with respect to the first case 11 at a transition from the open state to the closed state, as an example, the "second protruding portion (the tip end P22a of the plate 26a)" which should be located at the position indicated by the dashed line with respect to the "first protruding portion (the tip ends P21a and P21b of the plate 25a)" may be misaligned in the "insertion direction (direction of the arrow C: downward in this example)" and may be located at the position indicated by the solid line. At this time, in the clamp sensor 3 of the present example, the second core member 22 is formed in a manner that the end portion Pa of the tip end P22a of the plate 26a becomes gradually thinner in the direction of the arrow A, and the first core member 21 is formed in a manner that the end portion Pb of the tip ends P21a and P21b of the plate 25a becomes gradually thinner in the direction of the arrow B opposite to the direction of the arrow A.

Therefore, when the second case 12 is further moved in the direction of the arrow A in the state in which the "second protruding portion" is misaligned with respect to the "first protruding portion" as described above, the foremost tip end (left end in the drawing) of the end portion Pa of the "second protruding portion" is unlikely to come into contact with the foremost tip end (right end in the drawing) of the end portion Pb of the "first protruding portion", and each of the "second protruding portions" can be smoothly inserted between the corresponding "first protruding portions". Therefore, by moving the second case 12 further in the direction of the arrow A, as illustrated in the left diagram of FIG. 19, each of the "first protruding portions" and the corresponding one of the "second protruding portions" are brought into a state of overlapping in the direction of the arrow C, and the magnetic core 20 is annularly arranged.

In this state, as illustrated in FIG. 8, the side surface of each of the "first protruding portions" of the first core member 21 and the side surface of the corresponding one of the "second protruding portions" of the second core member 22 are brought into a state of being in surface contact with each other over a sufficiently large area. In this way, the first core member 21 and the second core member 22 are coupled to each other with a sufficient magnetic coupling force. In this way, the transition of the clamp sensor 3 to the closed state is completed, and a suitable annular closed magnetic circuit is formed so as to surround the measurement target conducting wire X.

In addition, in the clamp sensor 3, as described above, in the state in which the magnetic core 20 is transitioned to the closed state and arranged annularly, the "first protruding portion (plate 25a)" on the tip end P21a side of the first core member 21 and the "second protruding portion (plate 26a)" on the tip end P22a side of the second core member 22 are configured to overlap each other in the insertion direction of the measurement target conducting wire X with respect to the magnetic core 20. In addition, in the clamp sensor 3, the "first protruding portion (plate 25a)" on the tip end P21b side of the first core member 21 and the "second protruding portion (plate 26a)" on the tip end P22b side of the second core member 22 are configured to overlap in the insertion direction of the measurement target conducting wire X with respect to the magnetic core 20.

Therefore, even if an external force is applied to the casing 10, for example, as a result of the cable 4 or the measurement target conducting wire X being pulled and a slight distortion of the casing occurs, in the closed state, a state in which the tip ends P21a and P21b of the first core member 21 are in contact with the "second protruding portion (plate 26a)" of the second core member 22 and the tip ends P22a and P22b of the second core member 22 are in contact with the "first protruding portion (plate 25a)" of the first core member 21 is suitably maintained. Therefore, a situation in which an unexpected gap occurs in the annular closed magnetic circuit (the magnetic core 20) is suitably avoided.

Furthermore, in the clamp sensor 3 of the present example, as described above, in the state in which the first core member 21 and the second core member 22 are transitioned to the closed state and arranged annularly, the first shield member 41 and the second shield member 42 are configured in a manner that the tip end P42s of the second shield member 42 is arranged close to the tip end P41a of the first shield member 41. Therefore, a situation in which a surrounding noise component infiltrates into the annular closed magnetic circuit can be suitably avoided. Thereafter, by operating the operation interface of the body portion 2 to start the measurement of the measurement amount, the measurement amount of the measurement target conducting wire X is measured based on the detection result of the clamp sensor 3.

In this way, the clamp sensor 3 includes the first core member 21 constituting a part, in the circumferential direction, of the magnetic core 20 arranged annularly in the closed state, and includes the second core member 22 formed separately from the first core member 21, the second core member 22 constituting another part, in the circumferential direction, of the magnetic core 20. The clamp sensor 3 includes the first case 11 accommodating the first core member 21, and the second case 12 configured to be slidable relative to the first case 11 and accommodating the second core member 22. The "first protruding portion (tip end of the plate 25a)" protruding in the circumferential direction is provided at at least one end portion, of both the end portions in the circumferential direction of the first core member 21, and the "second protruding portion (tip end of the plate 26a)" protruding in the circumferential direction is provided at at least one end portion, of both the end portions in the circumferential direction of the second core member 22. In the state in which the magnetic core 20 is transitioned to the closed state and arranged annularly, the "first protruding portion" and the "second protruding portion" are configured to overlap each other in the insertion direction.

In addition, the measuring device 1 includes the above-described clamp sensor 3 and the body portion 2 including the "measuring unit" that measures a predetermined measurement amount, based on the detection amount by the clamp sensor 3, of the measurement target conducting wire X inserted into the magnetic core 20 in the insertion direction.

Therefore, compared to a clamp sensor having a structure in which both the end portions in the circumferential direction of a first core member and both the end portions in the circumferential direction of a second core member are each formed in a planar shape orthogonal to the circumferential direction, and the end surface of the first core member and the end surface of the second core member make surface contact in the closed state, the clamp sensor 3 and the measuring device 1 can increase, when viewed along the insertion direction in the closed state, the contact area between the first core member 21 and the second core member 22 in the closed state by causing mutual contact between portions (the side surface of the "first protruding portion" and the "side surface of the second protruding portion") in which the "first protruding portion" provided at the at least one end portion (at both the end portions in the present example) of both the end portions in the circumferential direction of the first core member 21 overlaps the "second protruding portion" provided at the at least one end portion (at both the end portions in the present example) of both the end portions in the circumferential direction of the second core member 22. **In** this way, even if the magnetic core 20 is reduced in size, the first core member 21 and the second core member 22 can be coupled to each other with a sufficient magnetic coupling force in the closed state. In this way, the clamp sensor 3 can be further reduced in size to reliably and easily clamp the measurement target conducting wire X even in a narrow space, and the sensitivity of the clamp sensor 3 can be further improved.

In addition, the clamp sensor 3 is configured in a manner that the "first protruding portion" is provided at each of both the end portions in the circumferential direction of the first core member 21, the "second protruding portion" is provided at each of both the end portions in the circumferential direction of the second core member 22, and in the state in which the magnetic core 20 is transitioned to the closed state and arranged annularly, the "first protruding portion" on the one end side of the first core member 21 and the "second protruding portion" on the one end side of the second core member 22 overlap each other in the "insertion direction" and the "first protruding portion" on the other end side of the first core member 21 and the "second protruding portion" on the other end side of the second core member 22 overlap each other in the "insertion direction".

Therefore, the clamp sensor 3 and the measuring device 1 can increase the contact area at both the ends of both the core members 21 and 22, compared to a configuration in which the "first protruding portion" and the "second protruding portion" are provided only on the one end side of the first core member 21 and the second core member 22. In this way, the magnetic coupling force between the first core member 21 and the second core member 22 in the closed state can be sufficiently improved over the entire circumference of the annular magnetic core 20. In this way, a situation in which a portion having a lower detection sensitivity than other portions is generated at any position in the circumferential direction of the magnetic core 20 can be suitably avoided.

In addition, in the clamp sensor 3, at least one type of protruding portion selected from the group of the "first protruding portion" and the "second protruding portion" is provided as a plurality of protruding portions to be arranged side by side in the "insertion direction", and the "counterpart protruding portion" is interposed between the plurality of protruding portions of the "at least one type of protruding portion".

Therefore, according to the clamp sensor 3 and the measuring device 1, when the clamp sensor, in which the plurality of "first protruding portions" are arranged side by side in the insertion direction of the measurement target conducting wire X with respect to the magnetic core 20, is transitioned from the open state to the closed state by sliding the second case 12 relative to the first case 11 along the "virtual straight line (rough dashed line L2 illustrated in FIGS. 24 and 25)", even if foreign matter is adhered between the tip ends P21a and P21a or between the tip ends P21b and P21b of the first core member 21, the foreign matter can be pushed away by the "second protruding portion (tip ends P22a and P22b)" of the second core member 22. In addition, when the clamp sensor, in which a plurality of the "second protruding portions" are arranged side by side in the insertion direction of the measurement target conducting wire X with respect to the magnetic core 20, is transitioned from the open state to the closed state, even if foreign matter is adhered between the tip ends P22a and P22a or between the tip ends P22b and P22b of the second core member 22, the foreign matter can be pushed away by the "first protruding portion (tip ends P21a and P21b)" of the first core member 21. In this way, a state in which foreign matter is interposed between the first core member 21 and the second core member 22 in the closed state can be suitably avoided. Furthermore, even if an unintended external force is applied to the first case 11 or the second case 12 in a state in which the measurement target conducting wire X is clamped and a small distortion is generated in both the cases 11 and 12, the first core member 21 and the second core member 22 can be maintained in a state of being in contact with each other as a result of a protruding end portion of the "first protruding portion" coming into contact with the side surface of the "second protruding portion" and/or a protruding end portion of the "second protruding portion" coming into contact with the side surface of the "first protruding portion", and a state in which a gap is generated in the annular closed magnetic circuit can be suitably avoided. In this way, according to the clamp sensor 3 and the measuring device 1, the detection amount of the measurement target conducting wire X can be detected with high accuracy, and as a result, the measurement amount can be measured with high accuracy.

In this case, as in the clamp sensor 3 of the measuring device 1 of the present example, when the magnetic core 20 that is transitioned to the closed state and arranged annularly is viewed along the insertion direction of the measurement target conducting wire X with respect to the magnetic core 20, the second case 12 is configured to be slidable relative to the first case 11 along the virtual straight line (rough dashed line L2 in FIGS. 24 and 25) intersecting (in this example, orthogonal to) the inner circumferential side edge portion (portion indicated by the dashed line L1 illustrated in FIGS. 24 and 25) of the magnetic core 20 at both the tip ends P21a and P21b in the circumferential direction of the first core member 21. This enables the tip ends P22a and P22a of the second core member 22 to enter laterally between the tip ends P21a and P21a of the first core member 21 at a transition from the open state to the closed state. In this way, foreign matter present between the tip ends P21b and P21b can be suitably pushed away, and since the tip ends P22b and P22b of the second core member 22 can be caused to enter laterally between the tip ends P21b and P21b of the first core member 21, the foreign matter present between the tip ends P21b and P21b can be suitably pushed away. Therefore, according to the clamp sensor 3 of the present example having a sufficiently large intersection angle (90°, which is an angle within the angle range θ2 described above) of the virtual straight line with respect to the inner circumferential side edge portion of the magnetic core 20, the state in which a gap is generated in the annular closed magnetic circuit can be reliably avoided, the detection amount of the measurement target conducting wire X can be detected with high accuracy, and as a result, the measurement amount can be measured with high accuracy.

In addition, in the clamp sensor 3, at a transition from the closed state to the open state and at a transition from the open state to the closed state by sliding the second case 12 relative to the first case 11, the "second protruding portion" on the tip end P22a side is configured to pass through the position at which the "second protruding portion" overlaps the "first protruding portion" on the tip end P21b side in the insertion direction.

Therefore, according to the clamp sensor 3 and the measuring device 1, the clamp sensor 3 can be transitioned to the open state and then returned to the closed state without causing a situation in which the "second protruding portion" on the tip end P22a side and the "first protruding portion" on the tip end P21b side come into contact with each other and the sliding of the second case 12 relative to the first case 11 is hindered. In this way, when the measurement target conducting wire X is inserted inside the first core member 21, a situation is avoided in which the relative movement of the measurement target conducting wire X toward the inside of the first core member 21 is hindered by the second core member 22. In addition, when the measurement target conducting wire X is inserted inside the second core member 22, a situation is avoided in which the relative movement of the measurement target conducting wire X toward the inside of the second core member 22 is hindered by the first core member 21. Therefore, the measurement target conducting wire X can be clamped smoothly.

In addition, the clamp sensor 3 includes the first shield member 41 disposed at the outer circumferential portion of the first core member 21 and accommodated in the first case 11 together with the first core member 21, and includes the second shield member 42 disposed at the outer circumferential portion of the second core member 22 and accommodated in the second case 12 together with the second core member 22. The first shield member 41 is accommodated in the first case 11 in a manner that, when the clamp sensor 3 is transitioned from the closed state to the open state and transitioned from the open state to the closed state, of both the tip ends P41a and P41b of the first shield member 41 in the circumferential direction, the tip end P41b located near the tip end P21b of the plate 25a does not come into contact with the tip end P22b of the plate 26a (the first shield member 41 does not come into contact with the second core member 22). The second shield member 42 is accommodated in the second case 12 in a manner that, when the clamp sensor 3 is transitioned from the closed state to the open state and transitioned from the open state to the closed state, of both the tip ends P42a and P42b of the second shield member 42 in the circumferential direction, the tip end P42a located near the tip end P22a of the plate 26a does not come into contact with the tip end P21a of the plate 25a (the second shield member 42 does not come into contact with the first core member 21).

Therefore, according to the clamp sensor 3 and the measuring device 1, a situation can be suitably avoided in which a noise component infiltrates into the magnetic core 20 in the closed state due to the presence of the first shield member 41 and the second shield member 42, without causing a situation in which the sliding of the second core member 22 relative to the first core member 21 is hindered.

In addition, in the clamp sensor 3, the first shield member 41 is accommodated in the first case 11 in a manner that, when the clamp sensor 3 is transitioned from the closed state to the open state and transitioned from the open state to the closed state, the tip end P41b does not come into contact with the tip end P22a of the second core member 22, and the second shield member 42 is accommodated in the second core member 22 in a manner that, when the clamp sensor 3 is transitioned from the closed state to the open state and transitioned from the open state to the closed state, the tip end P42a does not come into contact with the tip end P21a of the first core member 21.

Therefore, according to the clamp sensor 3 and the measuring device 1, the clamp sensor 3 can be transitioned to the open state and then returned to the closed state without causing a situation in which the tip end P41b of the first shield member 41 and the tip end P22a of the second core member 22 come into contact with each other, or the tip end P42a of the second shield member 42 and the tip end P21b of the first core member 21 come into contact with each other and the sliding of the second case 12 relative to the first case 11 is hindered. In this way, when the measurement target conducting wire X is inserted inside the first core member 21, a situation is avoided in which the relative movement of the measurement target conducting wire X toward the inside of the first core member 21 is hindered by the second core member 22 and the second shield member 42. In addition, when the measurement target conducting wire X is inserted inside the second core member 22, a situation is avoided in which the relative movement of the measurement target conducting wire X toward the inside of the second core member 22 is hindered by the first core member 21 and the first shield member 41. Therefore, the measurement target conducting wire X can be clamped smoothly.

In addition, in the clamp sensor 3, the thickness gradually decreases in the insertion direction at the end portion Pb, of the "first protruding portion", that is located on the first direction side (the direction of the arrows B in each of the drawings), at the end portion Pb located on the "first direction" side of the "second protruding portion", at the end portion Pa, of the "second protruding portion", that is located on the second direction side (the direction of the arrow A in each of the drawings), and at the end portion Pa located on the "second direction" side of the "second protruding portion". The first direction is the direction in which the second case 12 slides relative to the first case 11 along the virtual straight line when the clamp sensor 3 is transitioned from the closed state to the open state. The second direction is the direction in which the second case 12 slides relative to the first case 11 along the virtual straight line when the clamp sensor 3 is transitioned from the open state to the closed state.

Therefore, according to the clamp sensor 3 and the measuring device 1, when the clamp sensor 3 is transitioned from the closed state to the open state and transitioned from the open state to the closed state, even if the "first protruding portion" and the "second protruding portion" are slightly misaligned in the insertion direction, the "first protruding portion" and the "second protruding portion" are unlikely to come into contact with each other in the sliding direction, and thus the second case 12 can be suitably slid with respect to the first case 11.

In addition, in the clamp sensor 3, the first case 11 is configured in a manner that the accommodating portion 11a that accommodates the first core member 21, and the gripping portion 11b are disposed side by side along the directions of the arrows A and B illustrated in FIGS. 2 and 3, and the second case 12 is configured so as to include the accommodating portion 12a that accommodates the second core member 22 and to be slidable relative to the first case 11 along the directions of the arrows A and B. Therefore, according to the clamp sensor 3 and the measuring device 1, the clamp sensor 3 formed in a rod shape (linear shape) can be easily inserted into the measurement target conducting wire X existing in a narrow place to reliably and easily clamp the measurement target conducting wire X, for example, compared to a configuration in which the accommodating portion 11a and the gripping portion 11b are arranged in an L shape in a side view.

Note that the configuration of the "clamp sensor" and the "measuring device" is not limited to the above example of the configuration of the clamp sensor 3 and the measuring device 1.

For example, an example of a configuration has been described in which, in order to completely open the notch 11s by retracting the second case 12 from above the accommodating portion 11a in the open state, at a transition from the closed state to the open state and at a transition from the open state to the closed state by sliding the second case 12 relative to the first case 11, the tip end P22a of the second core member 22 (the second protruding portion on the one end side) can pass through the position overlapping the tip end P21b of the first core member 21 (the first protruding portion on the other end side) in the insertion direction. Instead of such a configuration, a configuration can be adopted in which a part of the tip end portion side of the case 12 is located above the accommodating portion 11a in the open state, that is, a state is obtained in which the notch 11s is partially opened.

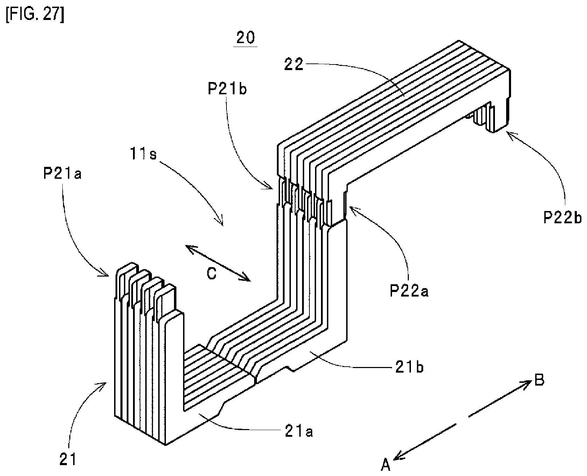

Specifically, as illustrated in FIG. 27, as an example, a configuration can be adopted in which the relative sliding of the second case 12 with respect to the first case 11 is stopped at a position where the tip end P22a of the second core member 22 (the second protruding portion on the one end side) overlaps the tip end P21b of the first core member 21 (the first protruding portion on the other end side) in the insertion direction at a transition from the closed state to the open state, that is, a configuration in which the tip end P22a of the second core member 22 (the second protruding portion on the one end side) overlaps the tip end P21b of the first core member 21 (the first protruding portion on the other end side) in the insertion direction in the closed state. Even when such a configuration is adopted, since the notch 11s is in a state of being opened sufficiently widely, the detection target conductor can be smoothly clamped.

In addition, at a transition from the closed state to the open state, a configuration can be adopted in which the second case 12 does not relatively slide with respect to the first case 11 to the position where the tip end P22a of the second core member 22 (the second protruding portion on the one end side) overlaps the tip end P21b of the first core member 21 (the first protruding portion on the other end side) in the insertion direction.

In addition, in a state in which a part of the tip end portion side of the case 12 is located above the accommodating portion 11a in the open state, that is, when a configuration is adopted in which the notch 11s is partially opened, the tip end P41b of the first shield member 41 may come into contact with the tip end P22a of the second core member 22 (the second protruding portion on the one end side) at a transition from the open state to the closed state, and the tip end P42a of the second shield member 42 may come into contact with the tip end P21b of the first core member 21 (the first protruding portion on the other end side) at a transition from the closed state to the open state and at a transition from the open state to the closed state.

In addition, an example of a configuration has been described in which at all of the "end portion A" and the "end portion C" of the "first protruding portion" and the "end portion B" and the "end portion D" of the "second protruding portion", the thickness along the "insertion direction" gradually decreases toward the end portions. However, by configuring the thickness along the "insertion direction" to gradually decrease toward the end portion at at least one location among the "end portion A" to the "end portion D", the "end portion" can be made less likely to come into contact with the other "protruding portions".

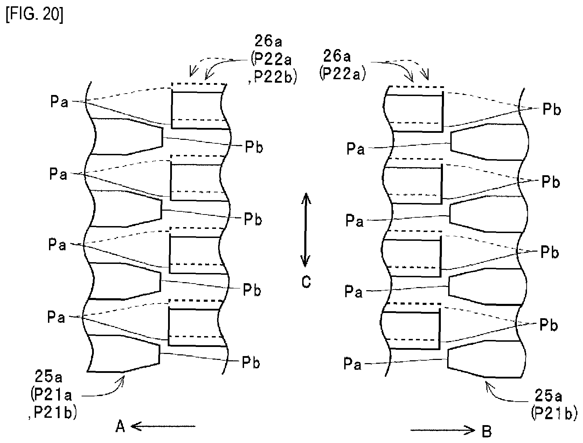

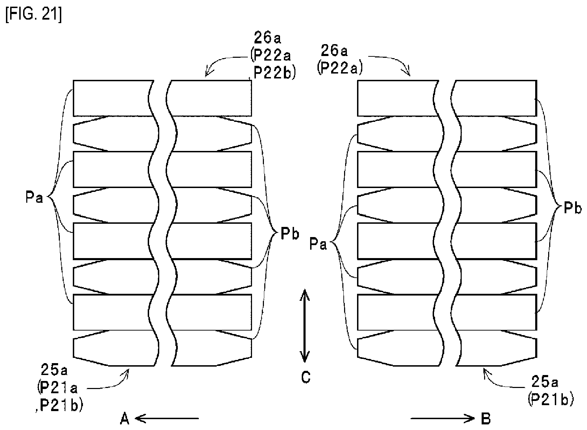

In this case, as an example, as illustrated in the right diagram of FIG. 20, if the first core member 21 is formed in a manner that the end portion Pa of the tip end P21b of the plate 25a becomes gradually thinner in the direction of the arrow A opposite to the arrow B, then even without gradually decreasing the thickness of the end portion Pb of the tip end P22a of the plate 26a, the foremost tip end (the right end in the drawing) of the end portion Pb of the "second protruding portion" is less likely to come into contact with the foremost tip end (the left end in the drawing) of the end portion Pa of the "first protruding portion". Therefore, each of the "second protruding portions" can be smoothly inserted between the corresponding "first protruding portions", and each of the "second protruding portions" can be smoothly moved in the direction of the arrow B with respect to the corresponding "first protruding portions", via a state in which each of the "first protruding portions" and the corresponding one of the "second protruding portions" are overlapped in the direction of the arrow C, as illustrated in the right diagram of FIG. 21. Note that, although not illustrated in the drawings, if the second core member 22 is formed in a manner that the end portion Pb of the tip end P22b of the plate 26a becomes gradually thinner in the direction of the arrow B, then even without gradually decreasing the thickness of the end portion Pa of the tip end P21a of plate 25a, the foremost tip end of the end portion Pb of the "second protruding portion" is less likely to come into contact with the foremost tip end of the end portion Pa of the "first protruding portion".

In addition, as an example, as illustrated in the left diagram of FIG. 20, if the first core member 21 is formed in a manner that the tip end P21a and/or the end portion Pb of the tip end P21b of the plate 25a become gradually thinner in the direction of the arrow B opposite to the arrow A, then even without gradually decreasing the thickness of the tip end P22a and/or the end portion Pb of the tip end P22b of the plate 26a, the foremost tip end (the left end in the drawing) of the end portion Pa of the "second protruding portion" is less likely to come into contact with the foremost tip end (the right end in the drawing) of the end portion Pb of the "first protruding portion". Therefore, each of the "second protruding portions" can be smoothly inserted between the corresponding "first protruding portions", and as illustrated in the left diagram of FIG. 21, each of the "first protruding portions" and the corresponding one of the "second protruding portions" can be smoothly moved in the direction of the arrow A until they are overlapped in the direction of the arrow C. Note that, although not illustrated in the drawings, if the second core member 22 is formed in a manner that the tip end P22a and/or the end portion Pa of the tip end P22b of the plate 26a become gradually thinner in the direction of the arrow A, then even without gradually decreasing the thickness of the tip end P21a and/or the end portion Pb of the tip end P21b of the plate 25a, the foremost tip end of the end portion Pb of the "second protruding portion" is less likely to come into contact with the foremost tip end of the end portion Pa of the "first protruding portion".

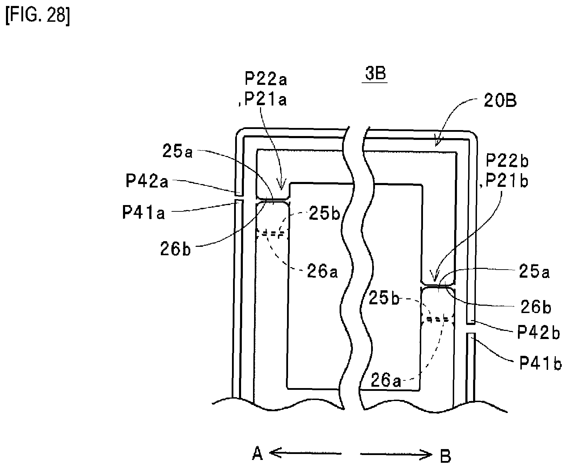

In addition, the clamp sensor 3 including the magnetic core 20 in which the first core member 21 is configured in a manner that the tip ends P21a and P21b overlap in the relative sliding direction of the second case 12 with respect to the first case 11 and the second core member 22 is configured in a manner that the tip ends P22a and P22b overlap in the sliding direction has been described as an example. Instead of such a configuration, as with a magnetic core 20B of a clamp sensor 3B illustrated in FIG. 28, the configuration may include the magnetic core 20B in which a first core member 21B (another example of the "first core member") is configured in a manner that the tip ends P21a and P21b do not overlap in the sliding direction and a second core member 22B (another example of the "second core member") is configured in a manner that the tip ends P22a and P22b do not overlap in the sliding direction. Note that the shapes and the like of the tip ends P21a, P21b, P22a, and P22b of both the core members 21B and 22B of the magnetic core 20B are the same as those of both the core members 21 and 22 of the magnetic core 20 described above, and a detailed description thereof is thus omitted.

In addition, although an example which includes the magnetic core 20 capable of forming an annular closed magnetic circuit having a rectangular shape in a side view in the closed state has been described, the shape in a side view of the annular closed magnetic circuit formed by the "magnetic core" in the closed state may be various types of shape, such as a circular shape, an elliptical shape, and an irregular shape.

In addition, the configuration including the magnetic core 20 in which the four "first protruding portions" are provided at each of the tip ends P21a and P21b of the first core member 21 and the four "second protruding portions" are provided at each of the tip ends P22a and P22b of the second core member 22 has been described as an example. However, the number of the "first protruding portions" provided on the one end side and the other end side of the "first core member" and the number of the "second protruding portions" provided on the one end side and the other end side of the "second core member" are not limited to this example. For example, the number of the "first protruding portions" and the number of the "second protruding portions" may be different. Specifically, as an example, the number of the "first protruding portions" may be three and the number of the "second protruding portions" may be two, or the number of the "first protruding portions" may be two and the number of the "second protruding portions" may be three. In addition, one type of protruding portion selected from the group consisting of the "first protruding portion" and the "second protruding portion" may be provided as a plurality of protruding portions, and the other type of protruding portion may be provided as one protruding portion.

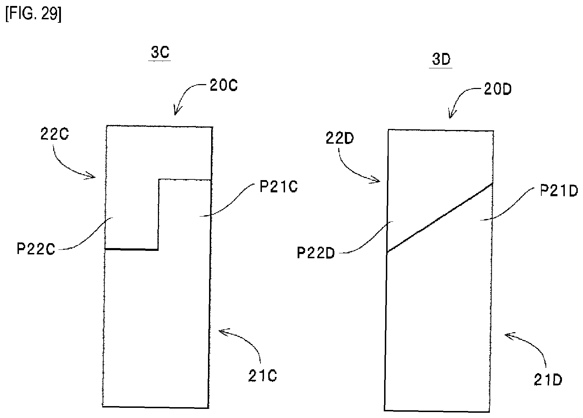

In addition, the number of each of the "first protruding portion" and the "second protruding portion" may be one. Specifically, as an example, as in a magnetic core 20C in a clamp sensor 3C illustrated in the left diagram of FIG. 29, one protruding portion as the "first protruding portion" can be formed at a tip end P21C of a first core member 21C (another example of the "first core member"), and one protruding portion as the "second protruding portion" can be formed at a tip end P22C of a second core member 22C (another example of the "second core member").

In this case, the "first protruding portion" and the "second protruding portion" are not limited to a "rectangular shape in a front view" (a shape in which a protruding end surface orthogonal to the annular magnetic circuit in a front view is present), such as the "first protruding portion" (tip end P21C) of the first core member 21C and the "second protruding portion" (tip end P22C) of the second core member 22C described above. Specifically, as in a magnetic core 20D in a clamp sensor 3D illustrated in the right diagram of FIG. 29, a tip end P21D (another example of the "first protruding portion") of a first core member 21D (another example of the "first core member") can be constituted by an inclined surface that obliquely intersects the annular magnetic circuit in a front view, and a tip end P22D (another example of the "second protruding portion") of a second core member 22D (another example of the "second core member") can be constituted by an inclined surface that obliquely intersects the annular magnetic circuit in a front view.

In addition, the configuration including the first core member 21 formed by stacking the plates 25a and 25b and the second core member 22 formed by stacking the plates 26a and 26b has been described as an example. Instead of such a configuration, the "magnetic core" may be constituted by forming a "first core member" having the same shape as the first core member 21 and a "second core member" having the same shape as the second core member 22 by molding, machining, or the like. Furthermore, although the configuration including the magnetic core 20 in which the gap G is provided in the first core member 21 has been described as an example, the "magnetic core" may be configured by providing a gap in the "second core member" without providing a gap in the "first core member", or the "magnetic core" may be configured without providing a gap in both the "first core member" and the "second core member".

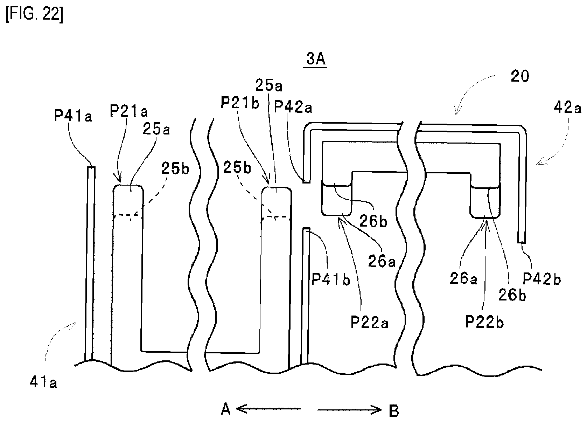

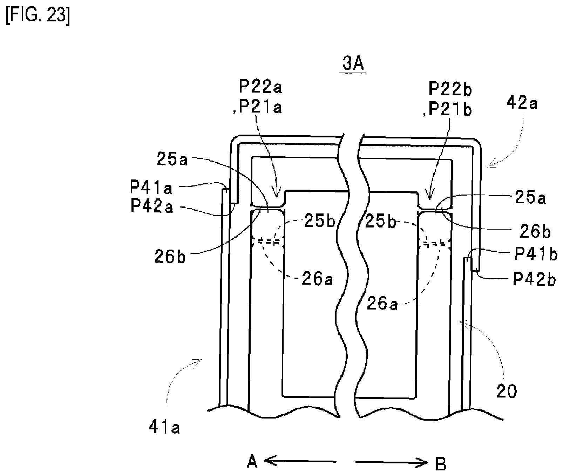

In addition, a shielding effect in the closed state can be improved by modifying the configuration of the shield 40 of the clamp sensor 3 described above. Specifically, in the clamp sensor 3A illustrated in FIGS. 22 and 23, a first shield member 41a as another example of the "first shield member" is accommodated in the "first case" in a manner that, of both the tip ends P41a and P41b of the first shield member 41a in the circumferential direction of the magnetic core 20, the tip end P41a located near the "first protruding portion on the other end side (the tip end P21a of the plate 25a)" is formed to protrude from the "first protruding portion on the other end side" in the circumferential direction, and when the clamp sensor 3 is transitioned from the open state (the state illustrated in FIG. 22) to the closed state (the state illustrated in FIG. 23), the tip end P42a of a second shield member 42a, which is another example of the "second shield member" (an edge portion located near the "second protruding portion on the other end side") comes into contact with the tip end P41a. In addition, in the clamp sensor 3A, the second shield member 42a is accommodated in the "second case" in a manner that, of both the tip ends P42a and P42b of the second shield member 42a in the circumferential direction of the magnetic core 20, the tip end P42b located near the "second protruding portion on the one end side (the tip end P22b of the plate 26a)" is formed to protrude from the "second protruding portion on the one end side" in the circumferential direction, and when the clamp sensor 3A is transitioned from the open state to the closed state, the tip end P42b of the first shield member 41a comes into contact with the tip end P42b.

By adopting such a configuration, when the clamp sensor 3A is transitioned to the open state or the closed state, the first shield member 41a and the second shield member 42a are in contact with the magnetic core 20 (the first core member and the second core member) and a situation in which noise infiltrates from a gap between both the shield members 41a and 41b in the closed state can be suitably avoided, without causing a situation in which the sliding of the second case with respect to the first case 11 is hindered.

In this case, in order to strengthen the magnetic coupling force compared to the clamp sensor having the structure in which both the end portions in the circumferential direction of the "first core member" and both the end portions in the circumferential direction of the "second core member" are formed in a planar shape orthogonal to the corresponding circumferential direction and the end surface of the "first core member" and the end surface of the "second core member" are brought into surface contact in the closed state, the area in which at least one end portion of both the end portions in the circumferential direction of the "first core member" and at least one end portion of both the end portions in the circumferential direction of the "second core member" are in contact with each other in the closed state may be made larger than the cross-sectional area in the direction orthogonal to the circumferential direction of the "first core member" and the cross-sectional area in the direction orthogonal to the circumferential direction of the "second core member".

Specifically, in the clamp sensor 3 and the like described above, the length (protruding length) in the circumferential direction and the length in the radial direction (sliding direction) of the "first protruding portion" are set to sufficient lengths so that the area of the side surface of the "first protruding portion" and the side surface of the "second protruding portion" are increased. This enables the area over which the "first core member" and the "second core member" to be in contact with each other is increased, and thus the side surface of the "first protruding portion" and the side surface of the "second protruding portion" are in surface contact with each other over a sufficiently large area in the closed state. In this way, when a configuration is adopted in which the side surface of the "first protruding portion" and the side surface of the "second protruding portion" are in contact with each other, by further increasing the length of at least one of the length (protruding length) in the circumferential direction and the length in the radial direction (sliding direction) of the "first protruding portion" and the "second protruding portion", the area over which the "first core member" and the "second core member" are in contact with each other is increased. Thus, the magnetic coupling force between the "first core member" and the "second core member" can be further strengthened.

Furthermore, in addition to the configuration in which the side surfaces of the "first protruding portion" and the "second protruding portion" are in contact with each other in the closed state, the protruding end surface of the "first protruding portion" can be configured to be in contact with the "second core member" or the protruding end surface of the "second protruding portion" can be configured to be in contact with the "first core member", so that the area over which the "first core member" and the "second core member" are in contact with each other is increased by an amount corresponding to the areas thereof. Thus, the magnetic coupling force between the "first core member" and the "second core member" can be further strengthened.

In addition, as in the clamp sensor 3 and the like described above, "at least one type of protruding portion selected from the group of the "first protruding portion" and the "second protruding portion" are provided as a plurality of protruding portions to be arranged side by side in the "insertion direction", and the "counterpart protruding portion" of the "first protruding portion" and the "second protruding portion" is interposed between the plurality of protruding portions of "at least one type of protruding portion", and thus, both side surfaces of the "counterpart protruding portion" are in contact with each side surface of the two protruding portions of the "at least one type of protruding portion", compared to a configuration in which one of each of the "first protruding portion" and the "second protruding portion" is provided. In this way, the area over which the "first core member" and the "second core member" are in contact with each other can be further increased, and the magnetic coupling force between the "first core member" and the "second core member" can be further strengthened.

Furthermore, as in the clamp sensor 3 and the like described above, in the closed state, the area over which the "first core member" and the "second core member" are in contact with each other can be sufficiently increased by providing the "first protruding portion" at each of both the end portions in the circumferential direction of the "first core member" and providing the "second protruding portion" at each of both the end portions in the circumferential direction of the "second core member", compared to the configuration in which the "first protruding portion" is provided at only one of both the end portions in the circumferential direction of the "first core member" and the "second protruding portion" is provided at only one of both the end portions in the circumferential direction of the "second core member". This is because the "first protruding portion" at one of the end portions in the circumferential direction of the "first core member" and the "second protruding portion" at one of the end portions in the circumferential direction of the "second core member" are in contact with each other, and the "first protruding portion" at the other end portion in the circumferential direction of the "first core member" and the "second protruding portion" at the other end portion in the circumferential direction of the "second core member" are in contact with each other. In this way, the magnetic coupling force between the "first core member" and the "second core member" can be sufficiently strengthened.

Note that, an example has been described in which the "first protruding portions" are provided at both the end portions in the circumferential direction of the "first core member" and the "second protruding portions" are provided at both the end portions in the circumferential direction of the "second core member". Instead of such a configuration, the "first protruding portion" can be provided only at one of both the end portions in the circumferential direction of the "first core member", and the "second protruding portion" can be provided only at one of both the end portions in the circumferential direction of the "second core member". Even in the configuration in which the "first protruding portion" and the "second protruding portion" are provided at only one of both the end portions as described above, the magnetic coupling force between the "first core member" and the "second core member" at the end portions where the "first protruding portion" and the "second protruding portion" are provided can be sufficiently increased.

### INDUSTRIAL APPLICABILITY

According to the present invention, in the closed state, by configuring the portions in which the first protruding portion and the second protruding portion overlap when viewed along the insertion direction (the side surface of the first protruding portion and the side surface of the second protruding portion) to be in contact with each other, the contact area between the first core member and the second core member in the closed state can be increased. Thus, even if the magnetic core is reduced in size, the first core member and the second core member can be coupled with a sufficient magnetic coupling force in the closed state, which enables the clamp sensor to be further reduced in size to reliably and easily clamp the detection target conductor even in a narrow place, and which further improves the sensitivity of the clamp sensor. In this way, the present invention can be widely applied to clamp sensors and measuring devices.

### REFERENCE SIGNS LIST

1 Measuring device
2 Body portion
3, 3A to 3C Clamp sensor
4 Cable
10 Casing
11 First case
11a, 12a Accommodating portion
11b Gripping portion
11s Notch
12 Second case
13 Operating knob
20, 20B to 20D Magnetic core
21, 21a, 21b, 21B First core member
22, 22B Second core member
25a, 25b, 26a, 26b Plate
30 Magnetic detection element
40 Shield
41, 41a First shield member
42, 42a Second shield member
50 Winding
G Gap
L1 Dashed line
L2, L2a, L2b Rough dashed line
P21a, P21b, P22a, P22b, P41a, P41b, P42a, P42b Tip end
Pa, Pb End portion
Ta, Tb Thickness
X Measuring target conducting wire
Θ1 Intersection angle
Θ2 Angle range

## Claims

1. A clamp sensor comprising:
a first core member constituting a part, in a circumferential direction, of a magnetic core arranged annularly in a closed state, and a second core member formed separately from the first core member, the second core member constituting another part, in the circumferential direction, of the magnetic core; and
a first case accommodating the first core member, and a second case configured to be slidable relative to the first case and accommodating the second core member,
wherein
when the magnetic core is transitioned to the closed state and arranged annularly, and the magnetic core is viewed along an insertion direction of a detection target conductor with respect to the magnetic core, the second case is configured to be slidable relative to the first case along a virtual straight line intersecting an inner circumferential side edge portion of the magnetic core at either of both of end portions, in the circumferential direction, of the first core member,
a first protruding portion protruding in the circumferential direction is provided at at least one end portion, of both the end portions in the circumferential direction of the first core member, and a second protruding portion protruding in the circumferential direction is provided at at least one end portion, of both of end portions in the circumferential direction of the second core member, and
in the state in which the magnetic core is transitioned to the closed state and arranged annularly, the first protruding portion and the second protruding portion are configured to overlap each other in the insertion direction.

2. The clamp sensor according to claim 1,
wherein
the first protruding portion is provided on each of both the end portions in the circumferential direction of the first core member, and the second protruding portion is provided on each of both the end portions in the circumferential direction of the second core member, and
in the state in which the magnetic core is transitioned to the closed state and arranged annularly, the first protruding portion on one side of the first core member and the second protruding portion on one side of the second core member overlap each other in the insertion direction, and the first protruding portion on another end side of the first core member and the second protruding portion on another end side of the second core member overlap each other in the insertion direction.

3. The clamp sensor according to claim 1 or 2, wherein
at least one type of protruding portion selected from the group of the first protruding portion and the second protruding portion is provided as a plurality of protruding portions to be arranged side by side in the insertion direction, and
a counterpart protruding portion selected from the group of the first protruding portion and the second protruding portion is configured to be inserted between the plurality of protruding portions of the at least one type of protruding portion.

4. The clamp sensor according to claim 2 or 3, wherein
at a transition from the closed state to an open state by sliding the second case relative to the first case, the second protruding portion on the one end side is configured to overlap the first protruding portion on the other end side in the insertion direction.

5. The clamp sensor according to any one of claims 2 to 4, wherein
at a transition from the closed state to an open state, and at a transition from the open state to the closed state by sliding the second case relative to the first case, the second protruding portion on the one end side is configured to pass through a position overlapping the first protruding portion on the other end slide in the insertion direction.

6. The clamp sensor according to any one of claims 1 to 5, comprising:
a first shield member disposed at an outer circumferential portion of the first core member and accommodated in the first case together with the first core member; and
a second shield member disposed at an outer circumferential portion of the second core member and accommodated in the second case together with the second core member,
wherein
the first shield member is accommodated in the first case to not come into contact with the second core member when the clamp sensor is transitioned from the closed state to an open state, and when the clamp sensor is transitioned from the open state to the closed state, and
the second shield member is accommodated in the second case to not come into contact with the first core member when the clamp sensor is transitioned from the closed state to the open state, and when the clamp sensor is transitioned from the open state to the closed state.

7. The clamp sensor according to any one of claims 2 to 6, comprising:
a first shield member disposed at an outer circumferential portion of the first core member and accommodated in the first case together with the first core member; and a second shield member disposed at an outer circumferential portion of the second core member and accommodated in the second case together with the second core member,
wherein
the first shield member is accommodated in the first case in a manner that, when the clamp sensor is transitioned from the closed state to an open state, and when the clamp sensor is transitioned from the open state to the closed state, of both of end portions of the first shield member in the circumferential direction, a first end portion located near the first protruding portion on the other end side does not come into contact with the second protruding portion on the other end side, and
the second shield member is accommodated in the second case in a manner that, when the clamp sensor is transitioned from the closed state to the open state, and when the clamp sensor is transitioned from the open state to the closed state, of both of end portions of the second shield member in the circumferential direction, a second end portion located near the second protruding portion on the one end side does not come into contact with the first protruding portion on the one end side.

8. The clamp sensor according to claim 7, wherein
the first shield member is accommodated in the first case in a manner that, when the clamp sensor is transitioned from the closed state to the open state, and when the clamp sensor is transitioned from the open state to the closed state, the first end portion does not come into contact with the second protruding portion on the one end side, and
the second shield member is accommodated in the second case in a manner that, when the clamp sensor is transitioned from the closed state to the open state, and when the clamp sensor is transitioned from the open state to the closed state, the second end portion does not come into contact with the first protruding portion on the other end side.

9. The clamp sensor according to any one of claims 1 to 8, wherein
the magnetic core is formed in a manner that a thickness thereof gradually decreases in the insertion direction toward a first direction side, at at least one location, of end portions at two locations including an end portion A and an end portion B, the first direction being a direction of sliding the second case relative to the first case along the virtual straight line when the clamp sensor is transitioned from the closed state to an open state, the end portion A being located to the first direction side at the first protruding portion as at least one type of protruding portion, and the end portion B being located to the first direction side at the second protruding portion as at least one type of protruding portion.

10. The clamp sensor according to any one of claims 1 to 9, wherein
the magnetic core is formed in a manner that a thickness thereof gradually decreases in the insertion direction toward a second direction side, at at least one location, of end portions at two locations including an end portion C and an end portion D, the second direction being a direction of sliding the second case relative to the first case along the virtual straight line when the clamp sensor is transitioned from an open state to the closed state, the end portion C being located to the second direction side at the first protruding portion as at least one type of protruding portion, and the end portion D being located to the second direction side at the second protruding portion as at least one type of protruding portion.

11. A measuring device comprising:
the clamp sensor described in any one of claims 1 to 10; and
a measuring unit configured to measure a measurement amount defined in advance based on a detection amount, by the clamp sensor, of the detection target conductor inserted in the insertion direction with respect to the magnetic core.
